# EUROPEAN PATENT APPLICATION

(11) **EP 4 576 987 A1**
(43) Date of publication of application: **25.06.2025**
(21) Application number: 24207800.4
(22) Date of filing: 21.10.2024
(51) Int. Cl.: H10D 30/01, H10D 30/00, H10D 64/23, B82Y 10/00

(54) **NANOSHEET FETS WITH SOURCE/DRAIN CONTACTS RECESSED IN SOURCE/DRAIN REGIONS WITH A POINTED CAPPING LAYER**

(30) Priority: 19.12.2023 KR 20230186303
(71) Applicant: SAMSUNG ELECTRONICS CO., LTD., Yeongtong-gu Suwon-si, Gyeonggi-do 16677 (KR)
(72) Inventor: JUNG, Seunggeun, 16677 Suwon-si, Gyeonggi-do (KR); KANG, Myunggil, 16677 Suwon-si, Gyeonggi-do (KR); KIM, Dongwoo, 16677 Suwon-si, Gyeonggi-do (KR); JEON, Yujin, 16677 Suwon-si, Gyeonggi-do (KR)
(74) Representative: Kuhnen & Wacker Patent- und Rechtsanwaltsbüro PartG mbB

(57) **Abstract**

The present disclosure provides a gate-all-around nanosheet FET integrated circuit device (10) including a plurality of nanosheets (N1-N3), a plurality of device isolation films, a plurality of gate lines (160) disposed on the plurality of device isolation films, a first source/drain region (SD) and a second source/drain region (SD) respectively disposed between the plurality of gate lines (160), wherein each of the first source/drain region and the second source/drain region includes a source/drain barrier layer (132), a source/drain body layer (134) on the source/drain barrier layer, and a source/drain capping layer (136) on the source/drain body layer, wherein a doping concentration of the source/drain capping layer is greater than a doping concentration of the source/drain body layer, the doping concentration of the source/drain body layer is greater than a doping concentration of the source/drain barrier layer. The source/drain capping layer (136) is recessed in the source/drain body layer (134) and includes a pointed portion (PT1) pointing downward, a source/drain contact structure (CA) is also recessed in the source/drain body layer (134) and is in contact with the source/drain capping layer. A method of manufacturing is also disclosed.

## Description

### BACKGROUND

The inventive concept relates to an integrated circuit device, and more particularly, to an integrated circuit device including a source/drain region.

Due to the development of electronics technology, down-scaling of integrated circuit devices has been rapidly progressing. Because semiconductor devices require high operating speed and operational accuracy, various studies have been conducted to optimize the structure of transistors included in semiconductor devices.

### SUMMARY

The inventive concept provides an integrated circuit device having improved electrical characteristics.

An integrated circuit device may include a plurality of device isolation films extending lengthwise in a first horizontal direction and spaced apart from each other in a second horizontal direction intersecting with the first horizontal direction, a plurality of gate lines disposed on the plurality of device isolation films and extending lengthwise in the second horizontal direction, a first source/drain region and a second source/drain region respectively disposed between the plurality of gate lines. The integrated circuit device may include at least one source/drain contact above the first source/drain region and the second source/drain region. The integrated circuit device may also include a plurality of source/drain contacts above the first source/drain region and the second source/drain region. The first source/drain region and/or the second source/drain region (respectively) includes a source/drain barrier layer and a source/drain body layer on the source/drain barrier layer.

For example, the first source/drain region and/or the second source/drain region may (respectively) include a source/drain capping layer. The source/drain capping layer may be on the source/drain body layer. A doping concentration of the source/drain capping layer may be greater than a doping concentration of the source/drain body layer. The doping concentration of the source/drain body layer may be greater than a doping concentration of the source/drain barrier layer. The source/drain capping layer may include a pointed portion.

. For example, the first source/drain region further includes a source/drain recess recessed inward from an upper surface of the first source/drain region. The source/drain capping layer may be disposed in the source/drain recess.

For example, the integrated circuit device may include a source/drain contact on the first source/drain region, and a backside source/drain contact below the second source/drain region. The first source/drain region and/or the second source/drain region may (respectively) include a source/drain barrier layer, and a source/drain body layer on the source/drain barrier layer. The second source/drain region may further include a backside source/drain recess recessed inward from a lower surface of the second source/drain region, and a backside source/drain capping layer disposed in the backside source/drain recess.

### BRIEF DESCRIPTION OF THE DRAWINGS

Embodiments will be more clearly understood from the following detailed description taken in conjunction with the accompanying drawings in which:
FIG. 1 is a diagram illustrating a planar layout of a cell block of an integrated circuit device according to example embodiments;
FIG. 2 is a planar layout diagram for explaining an integrated circuit device according to example embodiments;
FIG. 3A is a cross-sectional view taken along line X1-X1' of FIG. 2;
FIG. 3B is a cross-sectional view taken along line Y1-Y1' of FIG. 2;
FIG. 4 is an enlarged view of a region indicated by "EX2" in FIG. 3A;
FIG. 5 is a planar layout diagram for explaining an integrated circuit device according to other example embodiments;
FIG. 6A is a cross-sectional view taken along line X1-X1' of FIG. 5;
FIG. 6B is a cross-sectional view taken along line Y1-Y1' of FIG. 5;
FIG. 6C is a cross-sectional view taken along line Y2-Y2' of FIG. 5;
FIG. 7 is an enlarged view of a region indicated by "EX3" in FIG. 6A;
FIG. 8 is a diagram for explaining an integrated circuit device according to other example embodiments;
FIG. 9 is a diagram for explaining an integrated circuit device according to other example embodiments;
FIG. 10, FIG. 11, FIG. 12A, FIG. 12B, FIG. 13, FIG. 14A, FIG. 14B, FIG. 15, FIG. 16, FIG. 17, FIG. 18A, FIG. 18B, FIG. 19A, FIG. 19B, FIG. 20A, FIG. 20B, FIG. 21A, FIG. 21B, FIG. 22A, and FIG. 22B are diagrams showing a process sequence of a method of manufacturing an integrated circuit device according to example embodiments; and
FIG. 23A, FIG. 23B, FIG. 24A, FIG. 24B, FIG. 25A, FIG. 25B, FIG. 25C, FIG. 26A, FIG. 26B, FIG. 27A, FIG. 27B, FIG. 28A, FIG. 28B, FIG. 29A, FIG. 29B, FIG. 29C, FIG. 30A, FIG. 30B, FIG. 31A, FIG. 31B, FIG. 32A, FIG. 32B, FIG. 33A, FIG. 33B, FIG. 34A, FIG. 34B, FIG. 35A, and FIG. 35B are diagrams showing a process sequence of a method of manufacturing an integrated circuit device according to other example embodiments.

### DETAILED DESCRIPTION OF THE EMBODIMENTS

Hereinafter, embodiments of the present inventive concept will be described in detail with reference to the accompanying drawings. Like reference numerals are used to indicate like components in the drawings, and the descriptions thereof will not be repeated.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

In the present specification, a horizontal direction may include a first horizontal direction (e.g., the X direction) and a second horizontal direction (e.g., the Y direction) that intersect with each other. A direction intersecting with the first horizontal direction (e.g., the X direction) and the second horizontal direction (e.g., the Y direction) may be referred to as a vertical direction (e.g., the Z direction). In the present specification, a vertical level may be referred to as a height level in the vertical direction (e.g., the Z direction) of any configuration.

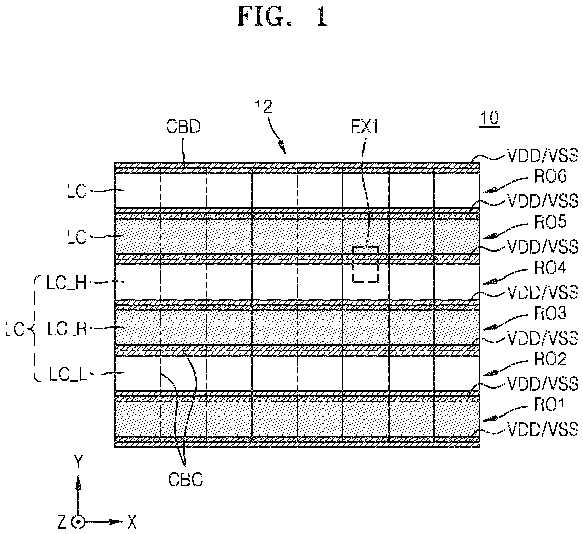

FIG. 1 is a diagram illustrating a plan layout of a cell block 12 of an integrated circuit device 10 according to example embodiments.

Referring to FIG. 1, the cell block 12 of the integrated circuit device 10 may include a plurality of logic cells LC including circuit patterns for configuring various circuits. The plurality of logic cells LC may be arranged in a matrix form in a first horizontal direction (e.g., the X direction) and a second horizontal direction (e.g., the Y direction) within the cell block 12.

Each of the plurality of logic cells LC may include a circuit pattern having a layout designed according to a place and route (PnR) technique to perform at least one logic function. The plurality of logic cells LC may have a function of performing various logic functions. In example embodiments, the plurality of logic cells LC may include a plurality of standard cells. In example embodiments, at least some of the plurality of logic cells LC may perform the same logic function. In other example embodiments, at least some of the plurality of logic cells LC may perform different logic functions.

The plurality of logic cells LC may include various types of logic cells including a plurality of circuit elements. For example, the plurality of logic cells LC may each include an AND, a NAND, an OR, a NOR, an exclusive OR (XOR), an exclusive NOR (XNOR), an inverter (INV), an adder (ADD), a buffer (BUF), a delay (DLY), a filter (FIL), a multiplexer (MXT/MXIT), an OR/AND/INVERTER (OAI), an AND/OR (AO), an AND/OR/INVERTER (AOI), a D flip-flop, a reset flip-flop, a master-slave flip-flop, a latch, or any combination thereof, but is not limited thereto.

In the cell block 12, at least some of the plurality of logic cells LC forming one row (RO1, RO2, RO3, RO4, RO5, or RO6) in the first horizontal direction (e.g., the X direction) may have the same width. Also, at least some of the plurality of logic cells LC forming one row (RO1, RO2, RO3, RO4, RO5, or RO6) may each have the same height. However, the present inventive concept is not limited to the embodiment illustrated in FIG. 1, and at least some of the plurality of logic cells LC forming one row (e.g., rows RO1, RO2, RO3, RO4, RO5, or RO6) may have different widths and heights.

An area of each of the plurality of logic cells LC included in the cell block 12 of the integrated circuit device 10 may be limited by a cell boundary CBD. A cell boundary contact portion CBC where each cell boundary CBD meets may be included between two logic cells LC that are adjacent to each other in the first horizontal direction (e.g., the X direction) or the second horizontal direction (e.g., the Y direction) among the plurality of logic cells LC.

In example embodiments, in the plurality of logic cells LC forming one row (e.g., rows RO1, RO2, RO3, RO4, RO5, or RO6), two logic cells LC adjacent to each other in the first horizontal direction (e.g., the X direction) may contact each other at the cell boundary contact portion CBC with no separation distance between them. In other example embodiments, in the plurality of logic cells LC forming one row (e.g., rows RO1, RO2, RO3, RO4, RO5, or RO6), two logic cells LC adjacent to each other in the first horizontal direction (e.g., the X direction) may be spaced apart from each other with a predetermined distance between them.

In example embodiments, in the plurality of logic cells LC forming one row (e.g., rows RO1, RO2, RO3, RO4, RO5, or RO6), two logic cells LC that are adjacent to each other may perform the same function. In this case, the two neighboring logic cells LC may have the same structure. In other example embodiments, in the plurality of logic cells LC forming one row (e.g., rows RO1, RO2, RO3, RO4, RO5, or RO6), two neighboring logic cells LC may perform different functions.

In example embodiments, one logic cell LC selected from among the plurality of logic cells LC included in the cell block 12 of the integrated circuit device 10 and another logic cell LC neighboring the selected logic cell LC in the second horizontal direction (Y in FIG. 1) may have symmetrical structures with respect to the cell boundary contact portion CBC between them. For example, a reference logic cell LC_R in the third row RO3 and a lower logic cell LC_L in the second row RO2 have a symmetrical structure with respect to the cell boundary contact portion CBC between them. In addition, the reference logic cell LC_R in the third row RO3 and an upper logic cell LC_H in the fourth row RO4 may have a symmetrical structure with respect to the cell boundary contact portion CBC between them.

FIG. 1 shows a cell block 12 including six rows (e.g., rows RO1, RO2, RO3, RO4, RO5, and RO6), but this is only an example, and the cell block 12 may include a variable number of rows selected as required, and one row may include a variable number of logic cells selected as needed.

One selected from among a plurality of ground lines VSS and a plurality of power lines VDD may be disposed between each of the plurality of rows (e.g., rows RO1, RO2, RO3, RO4, RO5, and RO6) including a plurality of logic cells LC arranged in a row in the first horizontal direction (e.g., the X direction). The plurality of ground lines VSS and the plurality of power lines VDD may extend lengthwise in the first horizontal direction (e.g., the X direction), may be spaced apart from each other in the second horizontal direction (e.g., the Y direction), and may be arranged alternately. Accordingly, the plurality of ground lines VSS and the plurality of power lines VDD may be arranged to overlap the cell boundary CBD in the second horizontal direction (e.g., the Y direction) of the logic cell LC.

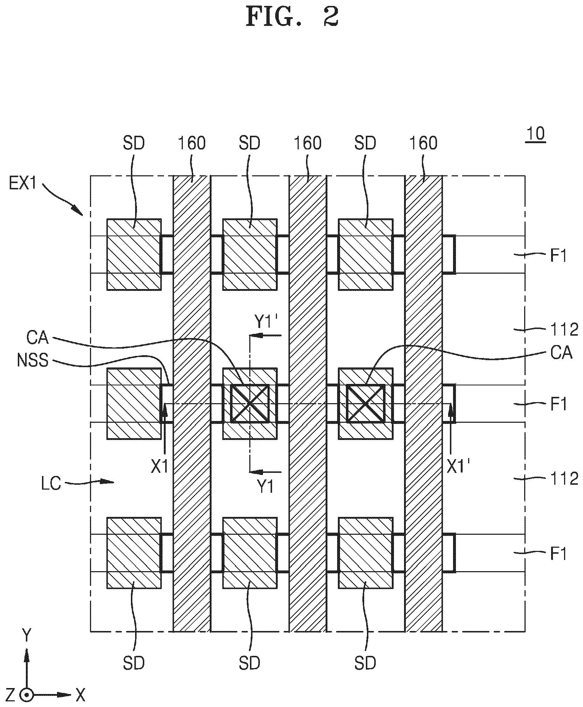

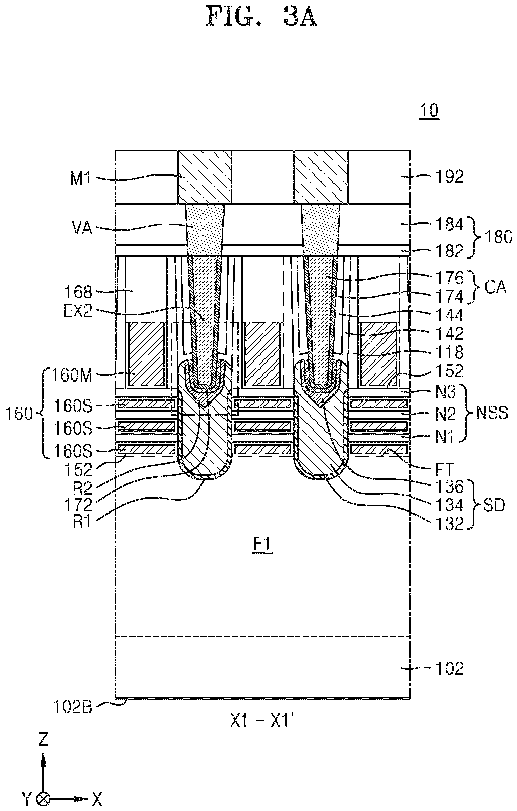

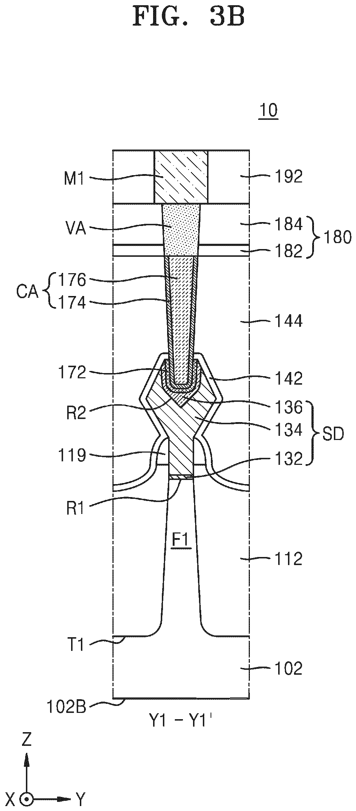

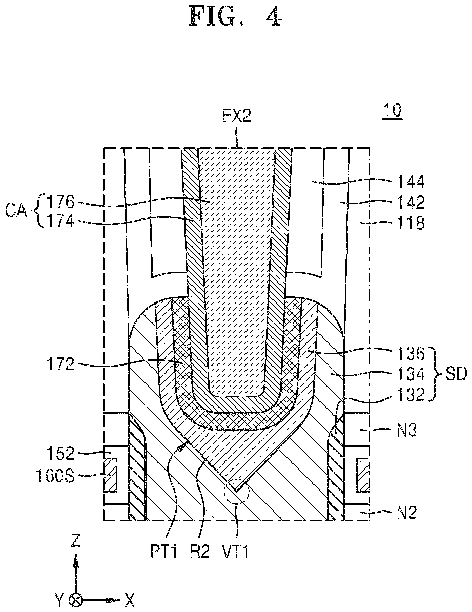

FIG. 2 is a planar layout diagram for explaining an integrated circuit device 10 according to embodiments. Specifically, FIG. 2 is an enlarged view of a region EX1 in FIG. 1. FIG. 3A is a cross-sectional view taken along line X1-X1' of FIG. 2. FIG. 3B is a cross-sectional view taken along line Y1-Y1' of FIG. 2. FIG. 4 is an enlarged view of a region EX2 in FIG. 3B.

Referring to FIGS. 2, 3A, 3B, and 4, the integrated circuit device 10 including an active region having a nanowire or nanosheet shape and an electric field effect transistor having a gate-all-around structure including a gate surrounding the active region will be described. For example, the integrated circuit device 10 may include a multi-bridge channel FET (MBCFET) device. However, the present inventive concept is not limited thereto, and the integrated circuit device 10 may include a planar FET device, a finFET device, etc. The integrated circuit device 10 may form a part of the plurality of logic cells LC illustrated in FIG. 1.

The integrated circuit device 10 may include a substrate 102 having a backside surface 102B and fin-type active regions F1 protruding from the substrate 102 to define a trench region T1 in the substrate 102 on the opposite side of the backside surface 102B. The fin-type active regions F1 may extend lengthwise in the first horizontal direction (e.g., the X direction) on the substrate 102 and may extend parallel to each other.

The substrate 102 may include a semiconductor, such as Si or Ge, or a compound semiconductor, such as SiGe, SiC, GaAs, InAs, InGaAs, or InP. The terms "SiGe", "SiC", "GaAs", "InAs", "InGaAs", and "InP" used in the present specification refer to materials composed of elements included in each term and are not chemical formulas representing stoichiometric relationships. The substrate 102 may include a conductive region, for example, a well doped with an impurity, or a structure doped with an impurity.

A device isolation film 112 may be disposed in the trench region T1 that defines the fin-type active region F1. The device isolation film 112 may cover and overlap a portion of a sidewall of the fin-type active region F1 in the trench region T1 and may extend away from the substrate 102 in the vertical direction (e.g., the Z direction). For example, the device isolation film 112 may contact sidewalls of the fin-type active regions F1 in the trench regions T1. The device isolation film 112 may include a silicon oxide film.

A plurality of gate lines 160 may be disposed on the fin-type active region F1. Each of the plurality of gate lines 160 may extend lengthwise in the second horizontal direction (e.g., the Y direction). A plurality of nanosheet stacks NSS may be disposed on a fin upper surface FT of the fin-type active region F1 in regions where the fin-type active region F1 and the plurality of gate lines 160 intersect. Each of the plurality of nanosheet stacks NSS may include at least one nanosheet facing the fin upper surface FT at a position spaced apart in the vertical direction (e.g., the Z direction) from the fin upper surface FT of the fin-type active region F1. The term "nanosheet" used herein refers to a conductive structure having a cross-section substantially perpendicular to a direction in which current flows. The term "nanosheet" should be understood to include nanowires.

The plurality of nanosheet stacks NSS may include a first nanosheet N1, a second nanosheet N2, and a third nanosheet N3, which overlap with each other in the perpendicular direction (e.g., the Z direction) in the fin-type active region F1. The first nanosheet N1, the second nanosheet N2, and the third nanosheet N3 may have different vertical distances (distances in the vertical direction) from the fin upper surface FT of the fin-type active region F1. The plurality of gate lines 160 may surround the first nanosheet N1, the second nanosheet N2, and the third nanosheet N3, which overlap with each other in the vertical direction (e.g., the Z direction) and are included in the nanosheet stack NSS.

Although FIG. 2 illustrates a case in which the planar shape of the nanosheet stack NSS is approximately square, it is not limited thereto. The nanosheet stack NSS may have various planar shapes depending on the planar shapes of each of the fin-type active region F1 and the gate line 160. In the present example, a configuration in which the plurality of nanosheet stacks NSS and the plurality of gate lines 160 are disposed in one fin-type active region F1, and a plurality of nanosheet stacks NSS are arranged in a row in the first horizontal direction (e.g., the X direction) in one fin-type active region F1 as an example. However, the number of nanosheet stacks NSS and gate lines 160 disposed in one fin-type active region F1 is not particularly limited.

The first nanosheet N1, the second nanosheet N2, and the third nanosheet N3 included in the nanosheet stack NSS may each function as a channel region. In example embodiments, the first nanosheet N1, the second nanosheet N2, and the third nanosheet N3 may each have a thickness selected within a range of about 4 nm to about 6 nm, but the thickness range is not limited thereto. Here, the thickness of each of the first nanosheet N1, the second nanosheet N2, and the third nanosheet N3 refers to a thickness or length in the vertical direction (e.g., the Z direction). In example embodiments, the first nanosheet N1, the second nanosheet N2, and the third nanosheet N3 may have substantially the same thickness in the vertical direction (e.g., the Z direction). In other example embodiments, at least some of the first nanosheet N1, the second nanosheet N2, and the third nanosheet N3 may have different thicknesses in the vertical direction (e.g., the Z direction). In example embodiments, the first nanosheet N1, the second nanosheet N2, and the third nanosheet N3 included in the nanosheet stack NSS may each include an Si layer, an SiGe layer, or any combination thereof.

The first nanosheet N1, the second nanosheet N2, and the third nanosheet N3 included in one nanosheet stack NSS have the same or similar sizes to each other in the first horizontal direction (e.g., the X direction). In other example embodiments, unlike illustrated in FIG. 3A, the first nanosheet N1, the second nanosheet N2, and the third nanosheet N3 included in one nanosheet stack NSS may have different sizes in the first horizontal direction (e.g., the X direction). In the present example, a case when the plurality of nanosheet stacks NSS each include three nanosheets is illustrated, but the present inventive concept is not limited thereto. For example, the nanosheet stack NSS may include at least one nanosheet, and the number of nanosheets constituting the nanosheet stack NSS is not particularly limited.

Each of the plurality of gate lines 160 may include a main gate portion 160M and a plurality of sub-gate portions 160S. The main gate portion 160M cover and overlaps n upper surface of the nanosheet stack NSS and may extend lengthwise in the second horizontal direction (e.g., the Y direction). The plurality of sub-gate portions 160S are integrally connected to the main gate portion 160M, and one sub-gate portion 160S may be disposed between each of the first nanosheet N1, the second nanosheet N2, and the third nanosheet N3 and between the first nanosheet N1 and the fin-type active region F1. In the vertical direction (e.g., the Z direction), a thickness of each of the plurality of sub-gate portions 160S may be less than a thickness of the main gate portion 160M.

A plurality of active region recesses R1 may be formed in the fin-type active region F1. A vertical level of the lowest surface of each of the plurality of active region recesses R1 may be less than a vertical level of the fin upper surface FT of the fin-type active region F1.

A plurality of source/drain regions SD may be disposed respectively within the plurality of active region recesses R1. The plurality of source/drain regions SD may each be disposed adjacent to at least one gate line 160 selected from among the plurality of gate lines 160. The plurality of source/drain regions SD may have surfaces facing the first nanosheet N1, the second nanosheet N2, and the third nanosheet N3 included in the adj acent nanosheet stack NSS, respectively. For example, the plurality of source/drain regions SD may overlap the first nanosheet N1, the second nanosheet N2, and the third nanosheet N3 in the first horizontal direction (e.g., the X direction).

Each of the plurality of gate lines 160 may include a metal, metal nitride, metal carbide, or any combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may be TiAlC. However, the material constituting the plurality of gate lines 160 is not limited to the above examples.

A gate dielectric film 152 may be disposed between the nanosheet stack NSS and the gate line 160. The gate dielectric film 152 may contact the nanosheet stack NSS and the gate line 160. In example embodiments, the gate dielectric film 152 may have a stacked structure of an interface dielectric film and a high-k dielectric film. The interface dielectric film may include a low dielectric material film having a dielectric constant of about 9 or less, for example, a silicon oxide film, a silicon oxynitride film, or any combination thereof. In example embodiments, the interface dielectric film may be omitted. The high-k dielectric film may include a material having a greater dielectric constant than the silicon oxide film. For example, the high dielectric film may have a dielectric constant in a range from about 10 to about 25. The high-k dielectric layer may include hafnium oxide, but is not limited thereto.

According to example embodiments, each of the gate dielectric film 152 and the gate line 160 may include a portion that overlaps the plurality of nanosheet stacks NSS in the vertical direction (e.g., the Z direction).

According to example embodiments, a plurality of transistors may be formed in regions where the plurality of nanosheet stacks NSS overlap the gate line 160 and the gate dielectric film 152. The plurality of transistors may include nano-sheet transistors. According to example embodiments, the plurality of transistors may include a PMOS transistor and an NMOS transistor. For example, the plurality of transistors may each be configured of at least one nanosheet stack NSS, the gate dielectric film 152 and the gate line 160 surrounding the at least one nanosheet stack NSS, and a plurality of source/drain regions SD facing the at least one nanosheet stack NSS in the first horizontal direction (e.g., the X direction).

In some embodiments, each of the plurality of nanosheet stacks NSS may include an undoped Si layer. In some other embodiments, each of the plurality of nanosheet stacks NSS may include a doped Si layer. For example, if the plurality of nanosheet stacks NSS constitute a PMOS transistor, each of the plurality of nanosheet stacks NSS may each include an Si layer doped with a p-type dopant, and if the plurality of nanosheet stacks NSS constitute an NMOS transistor, each of the plurality of nanosheet stacks NSS may each include an Si layer doped with an n-type dopant but are not limited thereto. The p-type dopant may be selected from B (boron) and Ga (gallium). The n-type dopant may be selected from phosphorus (P), arsenic (As), and antimony (Sb).

In example embodiments, each of the plurality of source/drain regions SD may have a multilayer structure. Each of the plurality of source/drain regions SD may include a source/drain barrier layer 132 and a source/drain body layer 134 on the source/drain barrier layer 132. The source/drain body layer 134 may contact the source/drain barrier layer 132. For example, in one source/drain region SD selected from among the plurality of source/drain regions SD, the source/drain barrier layer 132 may extend conformally on the upper surface of the active region recess R1, sidewalls of the plurality of nanosheet stacks NSS adjacent to the source/drain barrier layer 132, and sidewalls of the gate dielectric film 152. The source/drain barrier layer 132 may contact the fin-type active region F1. The source/drain body layer 134 on the source/drain barrier layer 132 may fill the active region recess R1.

In example embodiments, the plurality of source/drain regions SD may each include the source/drain barrier layer 132, the source/drain body layer 134, and a source/drain capping layer 136 on the source/drain body layer 134. The source/drain capping layer 136 may be disposed in a source/drain recess R2 recessed inward from an upper surface of each of the plurality of source/drain regions SD. In some embodiments, the source/drain capping layer 136 may be disposed in the source/drain recess R2 formed by recessing a portion of the source/drain body layer 134. The source/drain capping layer 136 may overlap a portion of the source/drain barrier layer 132 (e.g., a portion of the source/drain barrier layer 132 that cover and overlaps a lower surface of the source/drain body layer 134) in the vertical direction (e.g., the Z direction) and may overlap the source/drain body layer 134 in the vertical direction (e.g., the Z direction). In some other embodiments, the source/drain capping layer 136 may be disposed in the source/drain recess R2 formed by recessing a portion of the source/drain barrier layer 132 and a portion of the source/drain body layer 134. The source/drain capping layer 136 may overlap the source/drain barrier layer 132 and the source/drain body layer 134 in the vertical direction (e.g., the Z direction).

The source/drain recess R2 formed by recessing a portion of the source/drain barrier layer 132 and/or a portion of the source/drain body layer 134 may overlap at least one of the first nanosheet N1, the second nanosheet N2, and the third nanosheet N3 in the first horizontal direction (e.g., the X direction). In other words, the source/drain capping layer 136 may overlap at least one of the first nanosheet N1, the second nanosheet N2, and the third nanosheet N3 in the first horizontal direction (e.g., the X direction). For example, a lowermost surface of the source/drain capping layer 136 may be at a lower vertical level than upper surfaces of at least one of the first nanosheet N1, the second nanosheet N2, and the third nanosheet N3.

In some embodiments, the source/drain capping layer 136 may include a pointed portion PT1, and the pointed portion PT1 may include one vertex VT1. The pointed portion PT1 may be a lower region of the source/drain capping layer 136, and the vertex VT1 may be a portion of the pointed portion PT1 with the lowest vertical level in the vertical direction (e.g., the Z direction). However, this is an example, and the pointed portion PT1 may include at least one vertex. In a process of manufacturing the integrated circuit device 10, after forming the source/drain barrier layer 132 and the source/drain body layer 134, the source/drain recess R2 including an angular shape may be formed by etching a portion of the source/drain barrier layer 132 and the source/drain body layer 134. Because the source/drain capping layer 136 is epitaxially grown on the source/drain recess R2 having an angular shape, the source/drain capping layer 136 may include a pointed portion PT1. The source/drain capping layer 136 including the pointed portion PT1 may have relatively few defects within a film that may occur due to epitaxial growth. For example, the epitaxial growth of the source/drain capping layer 136 is described below in the description of a method of manufacturing the integrated circuit device 10. The source/drain capping layer 136 may include a crystalline material.

In example embodiments, a first group of the plurality of source/drain regions SD may configure a PMOS transistor. In this case, the plurality of source/drain regions SD may include a Si₁₋ₓGeₓ layer (or an Si₁₋ₓGeₓ film) doped with a p-type dopant (here, 0.0 < x≤ 0.6).

In some embodiments, in the source/drain region SD, the content ratio of Ge in the source/drain body layer 134 may be greater than the content ratio of Ge in the source/drain barrier layer 132, and the content ratio of Ge in the source/drain capping layer 136 may be greater than the content ratio of Ge in the source/drain body layer 134. In some embodiments, the content ratio of Ge in the source/drain barrier layer 132 may be greater than about 0.0 atomic% and less than or equal to about 20 atomic%, for example, greater than or equal to about 10 atomic% and less than or equal to about 20 atomic%. The content ratio of Ge in the source/drain body layer 134 may be in a range from about 30 atomic% to about 45 atomic%, for example, in a range from about 30 atomic% to about 40 atomic%. The content ratio of Ge in the source/drain capping layer 136 may be greater than about 40 atomic% and less than or equal to about 70 atomic%, for example, greater than or equal to about 45 atomic% and less than or equal to about 55 atomic%. However, the present inventive concept is not limited to the above examples.

In some embodiments, in the source/drain region SD, the content ratio of a p-type dopant in the source/drain body layer 134 may be greater than the content ratio of the p-type dopant in the source/drain barrier layer 132, and the content ratio of the p-type dopant in the source/drain capping layer 136 may be greater than the content ratio of the p-type dopant in the source/drain body layer 134. For example, the concentration of the p-type dopant in the source/drain capping layer 136 may be in a range from about 5 × 10²⁰ at/cm³ to about 2 × 10²¹ at/cm³. In some embodiments, the p-type dopant may be at least one selected from boron (B) and gallium (Ga) but is not limited thereto.

In other example embodiments, a second group of the plurality of source/drain regions SD may configure an NMOS transistor. In this case, the source/drain region SD may include an Si layer doped with an n-type dopant, an undoped Si layer, or any combination thereof.

In some embodiments, in the source/drain region SD, the source/drain barrier layer 132 may include an undoped Si layer, and the source/drain body layer 134 and the source/drain capping layer 136 may include an Si layer doped with an n-type dopant. In some other embodiments, in the source/drain region SD, the source/drain barrier layer 132, the source/drain body layer 134, and the source/drain capping layer 136 may be doped with an n-type dopant, but the content ratio of the n-type dopant in the source/drain body layer 134 may be greater than the content ratio of the n-type dopant in the source/drain barrier layer 132, and the content ratio of the n-type dopant in the source/drain capping layer 136 may be greater than the content ratio of the n-type dopant in the source/drain body layer 134. For example, the concentration of the n-type dopant in the source/drain capping layer 136 may be in a range from about 5 × 10²⁰ at/cm3 to about 2 × 10²¹ at/cm3. The n-type dopant may be at least one selected from P (phosphorus), As (arsenic), and Sb (antimony), but is not limited thereto.

In some embodiments, in the first group source/drain region SD constituting the PMOS transistor among the plurality of source/drain regions SD, a vertical level of the pointed portion PT1 of the source/drain capping layer 136 may overlap in the first horizontal direction (e.g., the X direction) with a sub-gate portion 160S surrounding a lower surface of the third nanosheet N3 located at the top among the plurality of sub-gate portions 160S.

In some other embodiments, in the second group of source/drain regions SD constituting the NMOS transistor among the plurality of source/drain regions SD, a vertical level of the pointed portion PT1 of the source/drain capping layer 136 may overlap in the first horizontal direction (e.g., the X direction) with a sub-gate portion 160S surrounding a lower surface of the first nanosheet N1 located at the bottom among the plurality of sub-gate portions 160S.

In example embodiments, the first group of source/drain regions SD constituting a PMOS transistor among the plurality of source/drain regions SD is electrically connected to a plurality of power lines VDD (see FIG. 1) and may thus receive a voltage of positive potential, and the second group source/drain region SD constituting an NMOS transistor among the plurality of source/drain regions SD is electrically connected to a plurality of ground lines VSS (see FIG. 1) and may thus receive a ground voltage or a negative potential voltage.

A metal silicide film 172 may be disposed on the upper surface of the plurality of source/drain regions SD. The metal silicide film 172 may include a metal comprising of Ti, W, Ru, Nb, Mo, Hf, Ni, Co, Pt, Yb, Tb, Dy, Er, or Pd. For example, the metal silicide film 172 may include titanium silicide but is not limited thereto. The metal silicide film 172 may contact the source/drain capping layer 136. The metal silicide film 172 may overlap the source/drain body layer 134 and the source/drain capping layer 136 in the first horizontal direction (e.g., the X direction).

A capping insulating pattern 168 may be disposed on the gate dielectric film 152 and the gate line 160. For example, the capping insulating pattern 168 may cover and overlap an upper surface of the main gate portion 160M and an upper surface of a portion of the gate dielectric film 152 surrounding the main gate portion 160M. The capping insulating pattern 168 may contact the upper surface of the main gate portion 160M and the upper surface of a portion of the gate dielectric film 152 surrounding the main gate portion 160M. The capping insulating pattern 168 may include a silicon nitride film or a silicon oxide film.

Both sidewalls of each of the gate line 160 and the capping insulating pattern 168 may be covered and overlapped with an outer insulating spacer 118. Specifically, the outer insulating spacer 118 may cover and overlap both sidewalls of the main gate portion 160M on the upper surface of the plurality of nanosheet stacks NSS. The outer insulating spacer 118 may be spaced apart from the gate line 160 with the gate dielectric film 152 therebetween. For example, the outer insulating spacer 118 may contact side surfaces of the gate dielectric film 152 and the capping insulating pattern 168.

A plurality of recess-side insulating spacers 119 may cover and overlap one sidewall of the source/drain region SD and the other sidewall facing the one sidewall, respectively, and may be disposed on an upper surface of the device isolation film 112. For example, the plurality of recess-side insulating spacers 119 may contact sidewalls of the source/drain body layer 134 of the source/drain region SD and the upper surface of the device isolation film 112. In example embodiments, each of the plurality of recess-side insulating spacers 119 may be integrally connected to the outer insulating spacer 118 adjacent thereto.

The plurality of outer insulating spacers 118 and the plurality of recess-side insulating spacers 119 may each include silicon nitride, silicon oxide, SiCN, SiBN, SiON, SiOCN, SiBCN, SiOC, or any combination thereof. The terms "SiCN", "SiBN", "SiON", "SiOCN", "SiBCN", and "SiOC" used in the present specification refer to materials composed of elements included in each term and are not chemical formulas representing stoichiometric relationships.

The plurality of source/drain regions SD, the plurality of metal silicide films 172, and the plurality of outer insulating spacers 118 may be covered and overlapped with the insulating liner 142. The insulating liner 142 may contact an upper surface of the device isolation film 112, side surfaces of the recess-side insulating spacers 119, surfaces of the source/drain body layer 134 and the source/drain capping layer 136, upper surfaces of the plurality of metal silicide films 172, and side surfaces of the plurality of outer insulating spacers 118. In example embodiments, the insulating liner 142 may be omitted. An inter-gate insulating film 144 may be disposed on the insulating liner 142. The inter-gate insulating film 144 may contact the insulating liner 142. If the insulating liner 142 is omitted, the inter-gate insulating film 144 may contact the plurality of source/drain regions SD.

The insulating liner 142 and the inter-gate insulating film 144 may be sequentially disposed on the plurality of source/drain regions SD and the plurality of metal silicide films 172. The insulating liner 142 and the inter-gate insulating film 144 may form an insulating structure. In example embodiments, the insulating liner 142 may include silicon nitride, SiCN, SiBN, SiON, SiOCN, SiBCN, or any combination thereof but is not limited thereto. The inter-gate insulating film 144 may include a silicon oxide film but is not limited thereto.

Both sidewalls of each of the plurality of sub-gate portions 160S included in the plurality of gate lines 160 may be spaced apart from the source/drain region SD with the gate dielectric film 152 therebetween. The gate dielectric film 152 may be disposed between the sub-gate portion 160S included in the gate line 160 and each of the first nanosheet N1, the second nanosheet N2, and the third nanosheet N3 and between the sub-gate portion 160S included in the gate line 160 and the source/drain region SD.

In addition, both sidewalls of each of the plurality of main gate portions 160M included in the plurality of gate lines 160 may be spaced apart from the source/drain region SD with the gate dielectric film 152 and the outer insulating spacer 118 therebetween. The gate dielectric film 152 may be disposed between the main gate portion 160M included in the gate line 160 and the outer insulating spacer 118 and between the main gate portion 160M and the uppermost third nanosheet N3.

A plurality of source/drain contacts CA may be respectively disposed on the plurality of source/drain regions SD. The plurality of source/drain contacts CA may each penetrate the inter-gate insulating film 144 and the insulating liner 142 in the vertical direction (e.g., the Z direction) and contact the metal silicide film 172. The inter-gate insulating film 144 and the insulating liner 142 may contact side surfaces of the plurality of source/drain contacts CA. Each of the plurality of source/drain contacts CA may be electrically connected to the source/drain region SD through the metal silicide film 172. The plurality of source/drain contacts CA are spaced apart from the main gate portion 160M in the first horizontal direction (e.g., the X direction) with the outer insulating spacer 118, the insulating liner 142, and the inter-gate insulating film 144 therebetween. Upper surfaces of the plurality of source/drain contacts CA, the plurality of capping insulating patterns 168, the outer insulating spacer 118, the insulating liner 142, and the inter-gate insulating film 144 may be coplanar.

The plurality of source/drain contacts CA may include a conductive barrier pattern 174 and a contact plug 176 sequentially stacked on the source/drain region SD. The conductive barrier pattern 174 may surround a lower surface and sidewalls of the contact plug 176 and may be in contact with the lower surface and sidewalls of the contact plug 176. The conductive barrier pattern 174 may be disposed between the metal silicide film 172 and the contact plug 176. The conductive barrier pattern 174 may contact an upper surface of the metal silicide film 172. In example embodiments, the conductive barrier pattern 174 may include a metal or metal nitride. For example, the conductive barrier pattern 174 may include Ti, Ta, W, TiN, TaN, WN, WCN, TiSiN, TaSiN, WSiN, or any combination thereof, but is not limited thereto. The contact plug 176 may include molybdenum (Mo), copper (Cu), tungsten (W), cobalt (Co), ruthenium (Ru), manganese (Mn), titanium (Ti), tantalum (Ta), and aluminum. (Al), a combination thereof, or any alloy thereof, but is not limited thereto.

An upper surface of each of the plurality of source/drain contacts CA, each of the plurality of capping insulating patterns 168, the outer insulating spacer 118, the insulating liner 142, and the inter-gate insulating film 144 may be covered and overlapped by an upper insulating structure 180. The upper insulating structure 180 may contact the upper surfaces of the plurality of source/drain contacts CA, the plurality of capping insulating patterns 168, the outer insulating spacer 118, the insulating liner 142, and the inter-gate insulating film 144. The upper insulating structure 180 may include an etch stop film 182 and an interlayer insulating film 184 sequentially stacked on each of the plurality of source/drain contacts CA, the plurality of capping insulating patterns 168, and the inter-gate insulating film 144. The etch stop film 182 may include silicon carbide (SiC), SiN, nitrogen-doped silicon carbide (SiC:N), SiOC, AlN, AlON, AlO, AlOC, or any combination thereof. The interlayer insulating film 184 may include an oxide film, a nitride film, an ultra-low-k (ULK) film having an ultra-low dielectric constant K in a range from about 2.2 to about 2.4, or any combination thereof. For example, the interlayer insulating film 184 may include a tetraethylorthosilicate (TEOS) film, a high density plasma (HDP) oxide film, a boro-phospho-silicate glass (BPSG) film, a flowable chemical vapor deposition (FCVD) oxide film, a SiON film, a SiN film, a SiOC film, a SiCOH film, or any combination thereof, but is not limited thereto.

A plurality of source/drain via contacts VA may be respectively disposed on the plurality of source/drain contacts CA. Each of the plurality of source/drain via contacts VA may penetrate the upper insulating structure 180 and contact the source/drain contact CA. The upper insulating structure 180 may contact side surfaces of the plurality of source/drain via contacts VA. Upper surfaces of the upper insulating structure 180 and the plurality of source/drain via contacts VA may be coplanar. The plurality of source/drain regions SD may be configured to be electrically connected to the plurality of source/drain via contacts VA through the metal silicide film 172 and the source/drain contact CA, respectively. A lower surface of each of the plurality of source/drain via contacts VA may be in contact with an upper surface of the source/drain contact CA. The plurality of source/drain via contacts VA may each be formed of or include molybdenum (Mo) or tungsten (W), but are not limited thereto.

An upper surface of the upper insulating structure 180 and each of the plurality of source/drain via contacts VA may be covered and overlapped with an upper insulating film 192. The upper insulating film 192 may contact the upper surface of the upper insulating structure 180. The constituent material of the upper insulating film 192 may be substantially the same as that described above with respect to the constituent material of the interlayer insulating film 184.

A plurality of upper wiring layers M1 may be disposed to penetrate the upper insulating film 192. Each of the plurality of upper wiring layers M1 may be electrically connected to one source/drain via contact VA selected from among the plurality of source/drain via contacts VA located therebelow. For example, each of the plurality of upper wiring layers M1 may contact an upper surface of a corresponding source/drain via contact VA. The plurality of upper wiring layers M1 may be formed of or include molybdenum (Mo), copper (Cu), tungsten (W), cobalt (Co), ruthenium (Ru), manganese (Mn), titanium (Ti), and tantalum (Ta), aluminum (Al), any combination thereof, or any alloy thereof, but are not limited thereto.

According to embodiments the present inventive concept, because the source/drain contact CA is electrically connected to the source/drain barrier layer 132 and the source/drain body layer 134 through the source/drain capping layer 136 that is relatively highly doped, electrical resistance, for example, contact resistivity, between the source/drain contact CA and the source/drain region SD may be reduced, thereby reducing the voltage drop.

In addition, because the source/drain capping layer 136 is formed in a shape including a pointed portion PT1, defects in the source/drain capping layer 136 may be relatively reduced during epitaxially growing the source/drain capping layer 136. Accordingly, the integrated circuit device 10 having improved reliability may be provided.

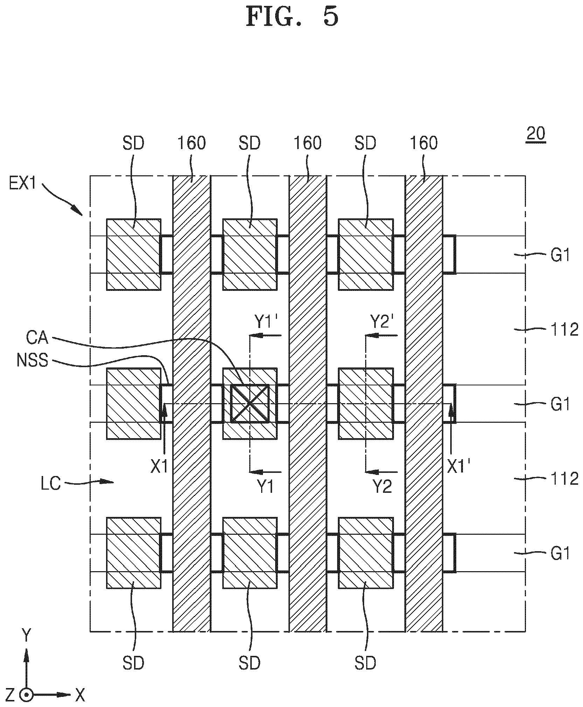

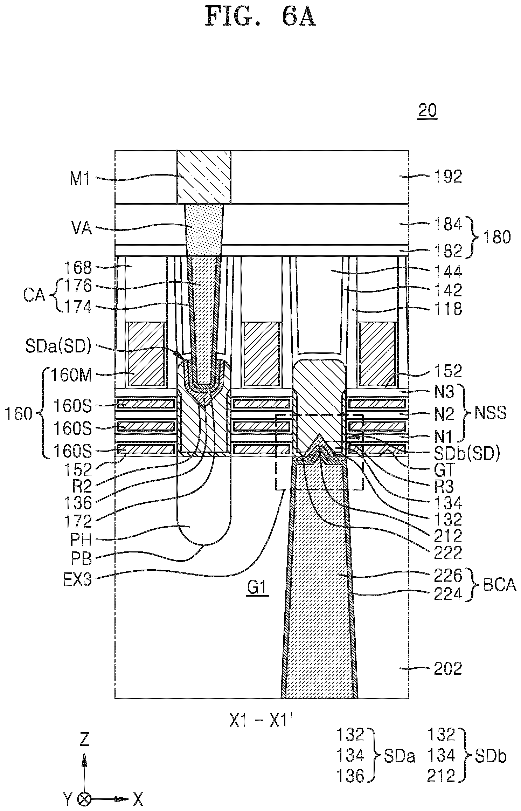

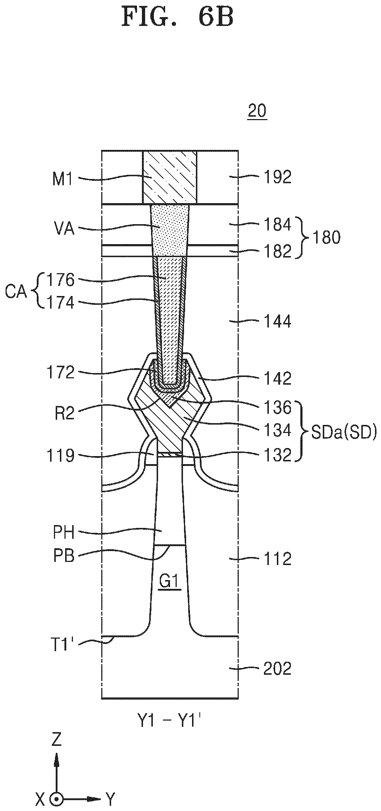

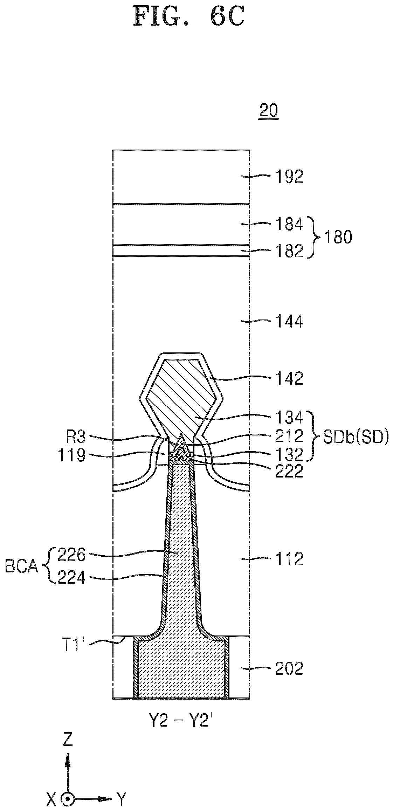

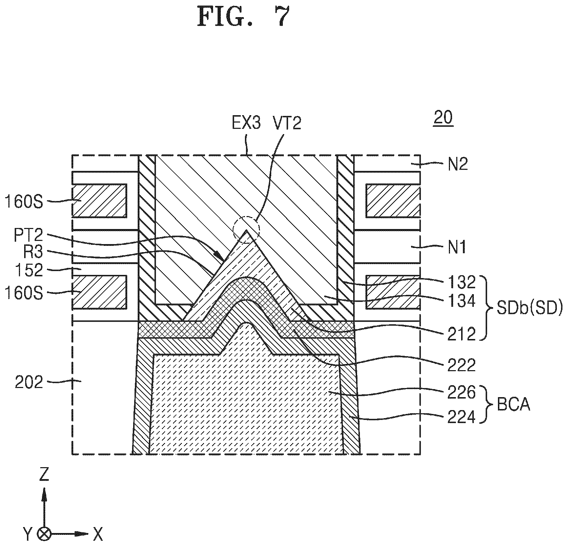

FIG. 5 is a planar layout diagram for explaining an integrated circuit device 20 according to other example embodiments. FIG. 6A is a cross-sectional view taken along line X1-X1' of FIG. 5. FIG. 6B is a cross-sectional view taken along line Y1-Y1' of FIG. 5. FIG. 6C is a cross-sectional view taken along line Y2-Y2' of FIG. 5. FIG. 7 is an enlarged view of a region EX3 in FIG. 6A.

Referring to FIGS. 5, 6A, 6B, 6C, and 7, the integrated circuit device 20 including a field effect transistor having a gate-all-around structure including an active region having a shape of a nanowire or nanosheet and a gate surrounding the active region is described. For example, the integrated circuit device 20 may include a multi-bridge channel FET (MBCFET) device. However, the present inventive concept is not limited thereto, and the integrated circuit device 20 may include a planar FET (FET) device, a finFET device, etc. The integrated circuit device 20 may configure a portion of the plurality of logic cells LC illustrated in FIG. 1.

Because the integrated circuit device 20 is configured generally and similarly to the integrated circuit device 10 described with reference to FIGS. 2, 3A, 3B, and 4, below, the differences from the integrated circuit device 10 are mainly described. Redundant descriptions will not be repeated.

The integrated circuit device 20 may include a gap-fill insulating film 202, and the gap-fill insulating film 202 may include gap-fill insulating regions G1 defining trench regions T1' in the gap-fill insulating film 202. The gap-fill insulating regions G1 may extend lengthwise in the first horizontal direction (e.g., the X direction) and may extend parallel to each other.

In example embodiments, the gap-fill insulating film 202 may be formed of or include silicon nitride (SiN), silicon oxide (SiO), SiCN, SiBN, SiON, SiOCN, SiBCN, SiOC, or any combination thereof, but is not limited thereto. The terms "SiN", "SiO", "SiCN", "SiBN", "SiON", "SiOCN", "SiBCN", and "SiOC" used in the present specification refer to materials composed of elements included in each term and are not chemical formulas representing stoichiometric relationships. In other example embodiments, the gap-fill insulating film 202 may include a low-k dielectric film. The low-k dielectric film may include fluorine-doped silicon oxide, organosilicate glass, carbon-doped oxide, porous silicon oxide, porous organosilicate glass, spin-on organic polymeric dielectric, spin-on silicon based polymeric dielectric, or any combination thereof but is not limited to the above examples.

A device isolation film 112 may be disposed on the trench regions T1' of the gap-fill insulating film 202. For example, the device isolation film 112 may contact sidewalls of the gap-fill insulating regions G1 in the trench regions T1'. The device isolation film 112 may be configured substantially the same as the configuration described above in the description of the integrated circuit device 10.

A plurality of gate lines 160 may be disposed on the gap-fill insulating regions G1. Each of the plurality of gate lines 160 may extend lengthwise in the second horizontal direction (e.g., the Y direction). On the gap-fill insulating regions G1, a plurality of nanosheet stacks NSS may be disposed in regions where the gap-fill insulating regions G1 cross the plurality of gate lines 160. The plurality of nanosheet stacks NSS may each include at least one nanosheet facing an upper surface GT of the gap-fill insulating region G1 at a position spaced apart from the upper surface GT of the gap-fill insulating region G1 in the vertical direction (e.g., the Z direction).

The plurality of nanosheet stacks NSS may include a first nanosheet N1, a second nanosheet N2, and a third nanosheet N3 that overlap each other in the vertical direction (e.g., the Z direction). The first nanosheet N1, the second nanosheet N2, and the third nanosheet N3 may have different vertical distances (Z distances) from the upper surface GT of the gap-fill insulating film 202.

FIG. 5 illustrates a case in which the planar shape of the nanosheet stack NSS is approximately square but is not limited thereto. Also, the present example shows a configuration in which the plurality of nanosheet stacks NSS and the plurality of gate lines 160 are disposed on the gap-fill insulating film 202, and the plurality of nanosheet stacks NSS are arranged in a row in the first horizontal direction (e.g., the X direction) on the gap-fill insulating film 202. However, the number of nanosheet stacks NSS and gate lines 160 disposed on the gap-fill insulating film 202 is not particularly limited.

The first nanosheet N1, the second nanosheet N2, and the third nanosheet N3 included in the nanosheet stack NSS may each function as a channel region. The first nanosheet N1, the second nanosheet N2, and the third nanosheet N3 may each be configured substantially the same as the configuration described above in the description of the integrated circuit device 10.

Each of the plurality of gate lines 160 may include a main gate portion 160M and a plurality of sub-gate portions 160S. The plurality of gate lines 160, the main gate portion 160M and the plurality of sub-gate portions 160S constituting the plurality of gate lines 160 may be configured substantially the same as those described above in the description of the integrated circuit device 10, respectively.

A place holder PH may be disposed on the gap-fill insulating region G1. In example embodiments, the place holder PH may include a SiGe film. For example, the place holder PH may include a single crystalline SiGe film, a polycrystalline SiGe film, an amorphous SiGe film, or any combination thereof. An upper surface of the place holder PH may be coplanar with an upper surface of the gap-fill insulating region G1.

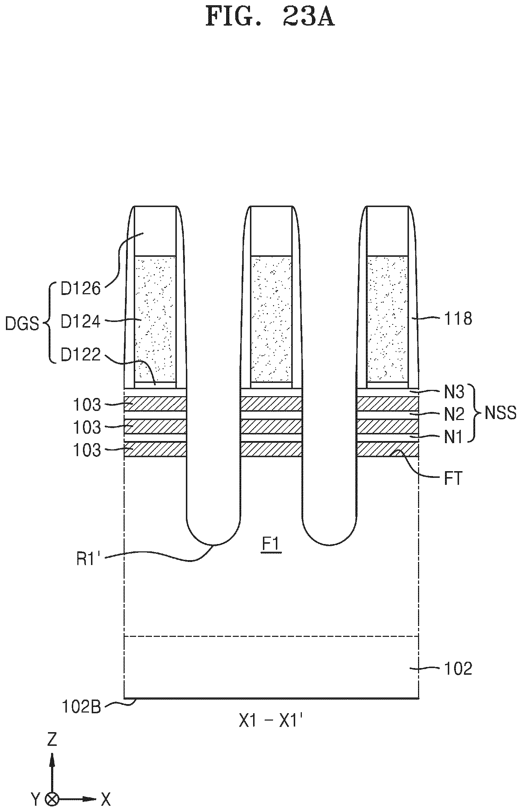

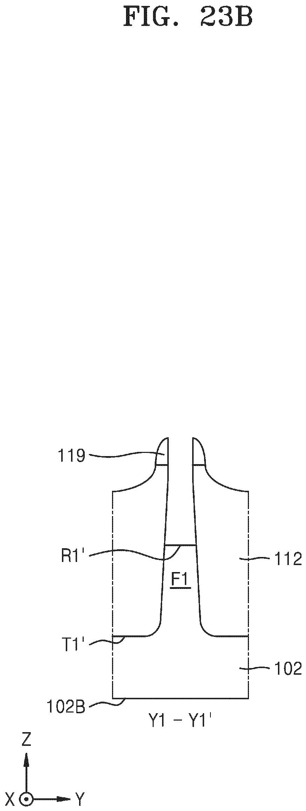

A vertical level of a lower surface PB of the place holder PH may be lower than a vertical level of the upper surface GT of the gap-fill insulation region G1. Referring to FIGS. 23A and 23B together, the lower surface PB of the place holder PH may correspond to a portion of the plurality of active region recesses R1' of the integrated circuit device 20. Referring to FIGS. 3A and 3B together, compared to the vertical level of the plurality of active region recesses R1 of the integrated circuit device 10, the vertical level of the lower surface PB of the place holder PH of the integrated circuit device 20 may be relatively low.

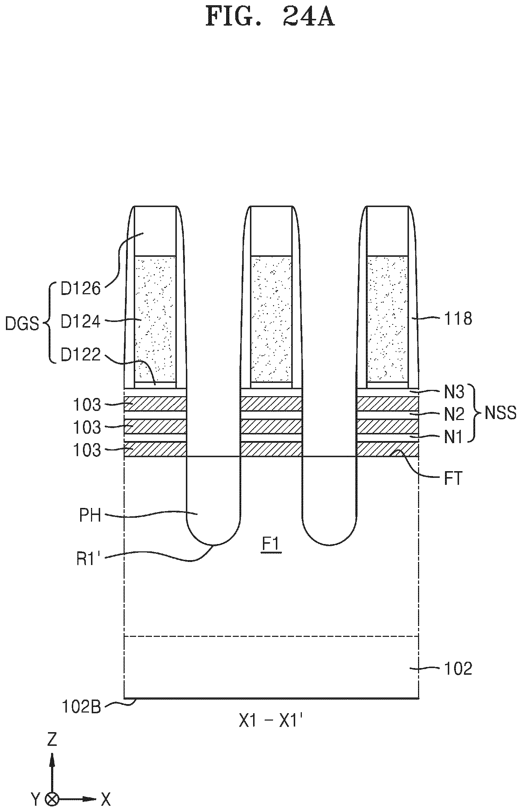

In example embodiments, the content of Ge in the place holder PH may be constant. The SiGe film constituting the place holder PH may have a constant Ge content selected within a range of about 5 atomic% to about 60 atomic%, for example, about 10 atomic% to about 40 atomic%. However, the content of Ge in the SiGe film constituting the place holder PH may be variably selected within a range so that an etch selectivity between the place holder PH and the fin-type active region F1 (see FIG. 24A) is different.

A plurality of source/drain regions SD may be disposed between the plurality of gate lines 160. The plurality of source/drain regions SD may each be disposed adjacent to at least one gate line 160 selected from among the plurality of gate lines 160. The plurality of source/drain regions SD may have surfaces facing the first nanosheet N1, the second nanosheet N2, and the third nanosheet N3 included in the adjacent nanosheet stack NSS, respectively. For example, the plurality of source/drain regions SD may overlap the first nanosheet N1, the second nanosheet N2, and the third nanosheet N3 in the first horizontal direction (e.g., the X direction).

A gate dielectric film 152 may be disposed between the nanosheet stack NSS and the gate line 160. The gate dielectric film 152 may contact the nanosheet stack NSS and the gate line 160. The gate dielectric film 152 may be configured substantially the same as the configuration described above in the description of the integrated circuit device 10.

According to example embodiments, each of the gate dielectric film 152 and the gate line 160 may include a portion that overlaps the plurality of nanosheet stacks NSS in the vertical direction (e.g., the Z direction).

According to example embodiments, a plurality of transistors may be formed in regions where the plurality of nanosheet stacks NSS, the gate line 160, and the gate dielectric film 152 each overlap. The plurality of transistors may include nano-sheet transistors. According to example embodiments, the plurality of transistors may include a PMOS transistor and an NMOS transistor. For example, the plurality of transistors each may be configured of at least one nanosheet stack NSS, the gate dielectric film 152 and the gate line 160 surrounding the at least one nanosheet stack NSS, and the plurality of source/drain regions SD facing the at least one nanosheet stack NSS in the first horizontal direction (e.g., the X direction).

In example embodiments, the plurality of source/drain regions SD may include a first source/drain region SDa and a second source/drain region SDb. The first source/drain region SDa may be connected to the source/drain contact CA through a metal silicide film 172, and the second source/drain region SDb may be connected to the backside source/drain contact BCA through a backside metal silicide film 222.

In some embodiments, the first source/drain region SDa and the second source/drain region SDb may be spaced apart from each other in the first horizontal direction (e.g., the X direction) with one nanosheet stack NSS therebetween. For example, the first source/drain region SDa may function as a drain region, and the second source/drain region SDb may function as a source region. In some embodiments, the first source/drain region SDa and the second source/drain region SDb may have the same shape, but the shapes are not limited thereto and may be different shapes. For example, the first source/drain region SDa and the second source/drain region SDb may have different horizontal widths or different vertical thicknesses.

In example embodiments, each of the plurality of source/drain regions SD may have a multilayer structure. In some embodiments, the plurality of source/drain regions SD may each include a source/drain barrier layer 132 and a source/drain body layer 134 on the source/drain barrier layer 132. For example, in one selected source/drain region SD among the plurality of source/drain regions SD, the source/drain barrier layer 132 may extend conformally on an upper surface of the place holder PH, sidewalls of the plurality of nanosheet stacks NSS adjacent to the source/drain barrier layer 132, and sidewalls of the gate dielectric film 152. For example, the source/drain barrier layer 132 may contact the upper surface of the place holder PH, the sidewalls of the plurality of nanosheet stacks NSS adjacent to the source/drain barrier layer 132, and the sidewalls of the gate dielectric film 152. The source/drain body layer 134 may partially fill spaces between the plurality of gate lines 160 on the source/drain barrier layer 132.

In example embodiments, the first source/drain region SDa may include the source/drain barrier layer 132 and a source/drain capping layer 136 on the source/drain body layer 134. A lower surface of the source/drain barrier layer 132 may be coplanar with a lower surface of the gate dielectric film 152 below the first nanosheet NS1 adjacent to the first source/drain region SDa. The source/drain capping layer 136 may be disposed in a source/drain recess R2 recessed inward from an upper surface of the first source/drain region SDa. The source/drain capping layer 136 and the source/drain recess R2 may be configured substantially the same as the configuration described above in the description of the integrated circuit device 10.

In example embodiments, the second source/drain region SDb may include the source/drain barrier layer 132, the source/drain body layer 134 and a backside source/drain capping layer 212 below the source/drain body layer 134. The backside source/drain capping layer 212 may be disposed in the backside source/drain recess R3 recessed inward from a lower surface of the second source/drain region SDb. In some embodiments, the backside source/drain capping layer 212 may be disposed in a backside source/drain recess R3 formed by recessing a portion of the source/drain barrier layer 132 (e.g., a portion of the source/drain barrier layer 132 that cover and overlaps a lower surface of the source/drain body layer 134) and a portion of the source/drain body layer 134. The backside source/drain capping layer 212 may penetrate a portion of the source/drain barrier layer 132 and the source/drain body layer 134. The backside source/drain capping layer 212 may contact the source/drain barrier layer 132 and the source/drain body layer 134. In example embodiments, the backside source/drain capping layer 212 may be surrounded by the source/drain barrier layer 132 and the source/drain body layer 134.

The backside source/drain recess R3 formed by recessing a portion of the source/drain barrier layer 132 and a portion of the source/drain body layer 134 may overlap at least one nanosheet (e.g., the first, second, or third nanosheets N1, N2, or N3) in the first horizontal direction (e.g., the X direction). In other words, the backside source/drain capping layer 212 may overlap at least one nanosheet (e.g., the first, second, or third nanosheets N1, N2, or N3) in the first horizontal direction (e.g., the X direction).

In some embodiments, the backside source/drain capping layer 212 may include a pointed portion PT2 (or at least one pointed portion PT2), and the pointed portion PT2 may include one vertex VT2. The pointed portion PT2 may be an upper region of the backside source/drain capping layer 212, and the vertex VT2 may be a portion of the pointed portion PT2 with the highest vertical level in the vertical direction (e.g., the Z direction). However, this is an example, and the pointed portion PT2 may include at least one vertex.

In the process of manufacturing the integrated circuit device 20, after forming the source/drain barrier layer 132 and the source/drain body layer 134, the backside source/drain recess R3 including an angular shape may be formed by etching a portion of the source/drain barrier layer 132 and the source/drain body layer 134. Because the backside source/drain capping layer 212 is epitaxially grown on the backside source/drain recess R3 having an angular shape, the backside source/drain capping layer 212 may include a pointed portion PT2. The backside source/drain capping layer 212 including the pointed portion PT2 may have relatively few defects in a film that may occur due to epitaxial growth. For example, the epitaxial growth of the backside source/drain capping layer 212 is described below in the description of a method of manufacturing the integrated circuit device 20. The backside source/drain capping layer 212 may include crystalline material.

In example embodiments, a first group of the plurality of source/drain regions SD may configure a PMOS transistor. In this case, the plurality of source/drain regions SD may include a Si-1-xGex layer doped with a p-type dopant (here, 0.0 < x≤ 0.6).

In some embodiments, the content ratio of Ge in the source/drain body layer 134 may be greater than the content ratio of Ge in the source/drain barrier layer 132, and the content ratio of Ge in the source/drain capping layer 136 and the content ratio of Ge in the backside source/drain capping layer 212 may be greater than the content ratio of Ge in the source/drain body layer 134. In some embodiments, the content ratio of Ge in the source/drain barrier layer 132 may be greater than about 0.0 atomic% and less than or equal to about 20 atomic%, for example, in a range from about 10 atomic% to about 20 atomic%. The content ratio of Ge in the source/drain body layer 134 may be in a range from about 30 atomic% to about 45 atomic%, for example, about 30 atomic% to about 40 atomic%. The content ratio of Ge in the source/drain capping layer 136 and the content ratio of Ge in the backside source/drain capping layer 212 may be greater than about 40 atomic% and less than or equal to about 70 atomic%, for example, in a range from about 45 atomic% to about 55 atomic%. However, the present inventive concept is not limited to the above examples.

In some embodiments, in the source/drain region SD, the content ratio of a p-type dopant in the source/drain body layer 134 may be greater the content ratio of the p-type dopant in the source/drain barrier layer 132, and the content ratio of the p-type dopant in the source/drain capping layer 136 and the backside source/drain capping layer 212 may be greater than the content ratio of the p-type dopant in the source/drain body layer 134. For example, the concentration of the p-type dopant in the source/drain capping layer 136 and the backside source/drain capping layer 212 may be in a range from about 5 × 10²⁰ at/cm³ to about 2 × 10²¹ at/cm³. In some embodiments, the p-type dopant may be at least one selected from boron (B) and gallium (Ga) but is not limited thereto.

In other example embodiments, a second group of the plurality of source/drain regions SD may configure an NMOS transistor. In this case, the source/drain region SD may include an Si layer doped with an n-type dopant, an undoped Si layer, or any combination thereof.

In some embodiments, the source/drain barrier layer 132 may include an undoped Si layer, and the source/drain body layer 134, the source/drain capping layer 136, and the backside source/drain capping layer 212 may include an Si layer doped with an n-type dopant. In some other embodiments, in the source/drain region SD, the source/drain barrier layer 132, the source/drain body layer 134, the source/drain capping layer 136, and the backside source/drain capping layer 212 may include an Si layer doped with an n-type dopant. The content ratio of the n-type dopant in the source/drain body layer 134 may be greater than the content ratio of the n-type dopant in the source/drain barrier layer 132, and the content ratio of the n-type dopant in the source/drain capping layer 136 and the backside source/drain capping layer 212 may be greater than the content ratio of the n-type dopant in the source/drain body layer 134. For example, the concentration of the n-type dopant in the source/drain capping layer 136 and the backside source/drain capping layer 212 may be in a range from about 5 × 10²⁰ at/cm³ to about 2 × 10²¹ at/cm³. The n-type dopant may be at least one selected from P (phosphorus), As (arsenic), and Sb (antimony) but is not limited thereto.

In some embodiments, in the first group source/drain region SD constituting the PMOS transistor among the plurality of source/drain regions SD, a vertical level of the pointed portion PT1 of the source/drain capping layer 136 may overlap in the first horizontal direction (e.g., the X direction) with a sub-gate portion 160S surrounding a lower surface of the third nanosheet N3 located at the top among the plurality of sub-gate portions 160S.

In some other embodiments, in the second group source/drain region SD constituting the NMOS transistor among the plurality of source/drain regions SD, a vertical level of the pointed portion PT1 of the source/drain capping layer 136 may overlap in the first horizontal direction (e.g., the X direction) with a sub-gate portion 160S surrounding a lower surface of the first nanosheet N1 located at the bottom among the plurality of sub-gate portions 160S.

In example embodiments, the first group source/drain region SD constituting a PMOS transistor among the plurality of source/drain regions SD is electrically connected to a plurality of power lines VDD (see FIG. 1) and may thus receive a voltage of positive potential, and the second group source/drain region SD constituting an NMOS transistor among the plurality of source/drain regions SD is electrically connected to a plurality of ground lines VSS (see FIG. 1) and may thus receive a ground voltage or a negative potential voltage.

A metal silicide film 172 may be disposed on the upper surface of the first source/drain region SDa. The metal silicide film 172 may include a metal comprising of Ti, W, Ru, Nb, Mo, Hf, Ni, Co, Pt, Yb, Tb, Dy, Er, or Pd. For example, the metal silicide film 172 may include titanium silicide but is not limited thereto.

A capping insulating pattern 168 may be disposed on the gate dielectric film 152 and the gate line 160. Both sidewalls of each of the gate line 160 and the capping insulating pattern 168 may be covered and overlapped with an outer insulating spacer 118. A plurality of recess-side insulating spacers 119 may cover and overlap one sidewall of the source/drain region SD and the other sidewall facing the one sidewall, respectively, and may be disposed on an upper surface of the device isolation film 112. The plurality of recess-side insulating spacers 119 may contact sidewalls of the source/drain region SD and the upper surface of the device isolation film 112. The plurality of source/drain regions SD, the plurality of metal silicide films 172, and the plurality of outer insulating spacers 118 may be covered and overlapped with the insulating liner 142. The insulating liner 142 and the inter-gate insulating film 144 may be sequentially disposed on the plurality of source/drain regions SD and the plurality of metal silicide films 172. The capping insulating pattern 168, the outer insulating spacer 118, the plurality of recess-side insulating spacers 119, the insulating liner 142, and the inter-gate insulating film 144 may be substantially the same as described above in the description of the integrated circuit device 10.

A source/drain contact CA may be disposed on the first source/drain region SDa. The source/drain contact CA may penetrate the inter-gate insulating film 144 and the insulating liner 142 in the vertical direction (e.g., the Z direction) and may contact the metal silicide film 172. The inter-gate insulating film 144 and the insulating liner 142 may contact side surfaces of the plurality of source/drain contacts CA. The source/drain contact CA may be electrically connected to the first source/drain region SDa through the metal silicide film 172. The source/drain contact CA may include a conductive barrier pattern 174 and a contact plug 176 sequentially stacked on the first source/drain region SDa. Upper surfaces of the plurality of source/drain contacts CA, the plurality of capping insulating patterns 168, the outer insulating spacer 118, the insulating liner 142, and the inter-gate insulating film 144 may be coplanar.

An upper surface of each of the source/drain contact CA, the plurality of capping insulating patterns 168, the outer insulating spacer 118, the insulating liner 142, and the inter-gate insulating film 144 may be covered and overlapped with the upper insulating structure 180. The upper insulating structure 180 may contact the upper surfaces of the plurality of source/drain contacts CA, the plurality of capping insulating patterns 168, the outer insulating spacer 118, the insulating liner 142, and the inter-gate insulating film 144. A source/drain via contact VA may be disposed on the source/drain contact CA. The source/drain via contacts VA may each penetrate the upper insulating structure 180 and contact the source/drain contact CA. The upper insulating structure 180 may contact side surfaces of the plurality of source/drain via contacts VA. Upper surfaces of the upper insulating structure 180 and the plurality of source/drain via contacts VA may be coplanar. An upper surface of each of the upper insulating structure 180 and the source/drain via contact VA may be covered and overlapped with an upper insulating film 192. The upper insulating film 192 may contact the upper surface of the upper insulating structure 180. An upper wiring layer M1 may be disposed to penetrate the upper insulating film 192. For example, the plurality of upper wiring layer M1 may contact an upper surface of the source/drain via contact VA. The source/drain contact CA, the upper insulating structure 180, the source/drain via contact VA, the upper insulating film 192, and the upper wiring layer M1 may be configured substantially the same as the configurations described above in the description of the integrated circuit device 10.

A backside metal silicide film 222 may be disposed on a lower surface of the second source/drain region SDb. The backside metal silicide film 222 may include a metal comprising of Ti, W, Ru, Nb, Mo, Hf, Ni, Co, Pt, Yb, Tb, Dy, Er, or Pd. For example, the backside metal silicide film 222 may include titanium silicide but is not limited thereto.

In example embodiments, the backside source/drain capping layer 212 may cover and overlap a portion of an upper surface of the backside metal silicide film 222, and the source/drain barrier layer 132 or the source/drain body layer 134 may cover and overlap the remaining portion of the upper surface of the backside metal silicide film 222. The backside metal silicide film 222 may contact a lower surface of the backside source/drain capping layer 212, a lower surface of the source/drain barrier layer 132, and a side surface of the gap-fill insulating film 202. In other example embodiments, the backside source/drain capping layer 212 may cover and overlap the upper surface of the backside metal silicide film 222.

A backside source/drain contact BCA may be disposed on the second source/drain region SDb. The backside source/drain contact BCA may penetrate the gap-fill insulating region G1 in the vertical direction (e.g., the Z direction) and contact the backside metal silicide film 222. The backside source/drain contact BCA may be electrically connected to the second source/drain region SDb through the backside metal silicide film 222. The backside source/drain contact BCA may include a conductive barrier pattern 224 and a contact plug 226 sequentially stacked on the second source/drain region SDb. The conductive barrier pattern 224 may surround an upper surface and sidewalls of the contact plug 226 and may contact the upper surface and sidewalls of the contact plug 226. The conductive barrier pattern 224 may be disposed between the backside metal silicide film 222 and the contact plug 226. The conductive barrier pattern 224 may contact the lower surface of the backside metal silicide film 222. Upper surfaces of each of the backside metal silicide film 222, the conductive barrier pattern 224, and the contact plug 226 may have a convex shape in a vertical direction (e.g., the Z direction). For example, the upper surface of the backside metal silicide film 222 and the conductive barrier pattern 224 may overlap the backside source/drain capping layer 212 in the first horizontal direction (e.g., the X direction), and the upper surface of the contact plug 226 may overlap the backside metal silicide film 222 in the first horizontal direction (e.g., the X direction). In example embodiments, the conductive barrier pattern 224 may include Ti, Ta, W, TiN, TaN, WN, WCN, TiSiN, TaSiN, WSiN, or any combination thereof but is not limited thereto. The contact plug 226 may include molybdenum (Mo), copper (Cu), tungsten (W), cobalt (Co), ruthenium (Ru), manganese (Mn), titanium (Ti), tantalum (Ta), and aluminum. (Al), any combination thereof, or any alloy thereof but is not limited thereto.

According to embodiments of the present inventive concept, because the relatively highly doped backside source/drain capping layer 212 is connected to the backside source/drain contact BCA through the backside metal silicide film 222, the electrical resistance, for example, contact resistivity between the backside source/drain contact BCA and the source/drain region SD is reduced, thereby reducing the voltage drop of the integrated circuit device 20.

In addition, because the backside source/drain capping layer 212 is formed in a shape including a pointed portion PT2, defects in the backside source/drain capping layer 212 may be relatively reduced during epitaxially growing the backside source/drain capping layer 212. Accordingly, the integrated circuit device 20 having improved reliability may be provided.

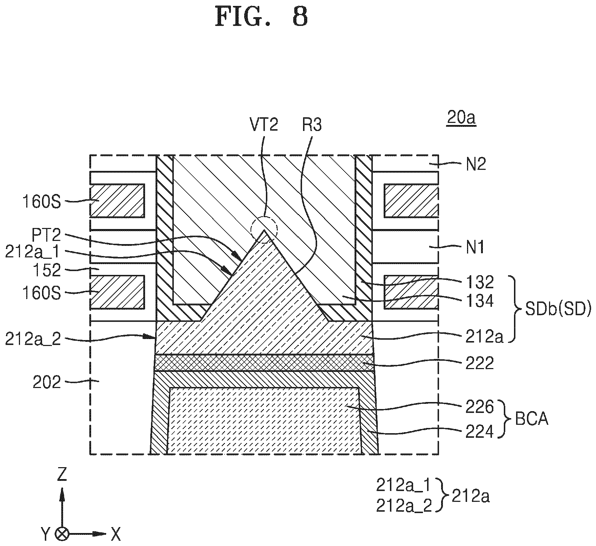

FIG. 8 is a diagram for explaining an integrated circuit device 20a according to other example embodiments. FIG. 8 shows a portion corresponding to the region EX3 in FIG. 6A.

Because the integrated circuit device 20a is configured generally and similarly to the integrated circuit device 20 described with reference to FIGS. 5, 6A, 6B, 6C, and 7, the differences from the integrated circuit device 20 are mainly described below. Redundant descriptions will not be repeated.

In example embodiments, the plurality of source/drain regions SD may include a first source/drain region SDa (see FIG. 6A) and a second source/drain region SDb. The first source/drain region SDa may be connected to the source/drain contact CA through the metal silicide film 172, and the second source/drain region SDb may be connected to the backside source/drain contact BCA through the backside metal silicide film 222.

In example embodiments, the second source/drain region SDb may include the source/drain barrier layer 132, the source/drain body layer 134 and a backside source/drain capping layer 212a below the source/drain body layer 134. The backside source/drain capping layer 212a may be disposed in the backside source/drain recess R3 recessed inward from a lower surface of the second source/drain region SDb. The backside source/drain capping layer 212a may penetrate a portion of the source/drain barrier layer 132 and the source/drain body layer 134.

The backside source/drain capping layer 212a may include a first capping portion 212a_1 that overlaps the source/drain barrier layer 132 and the source/drain body layer 134 in the first horizontal direction (e.g., the X direction), and a second capping portion 212a_2 that does not overlap the source/drain barrier layer 132 and the source/drain body layer 134 in the first horizontal direction (e.g., the X direction). The first capping portion 212a_1 may include a pointed portion PT2.

Sidewalls of the first capping portion 212a_1 may be surrounded by the source/drain barrier layer 132 and the source/drain body layer 134, and sidewalls of the second capping portion 212a_2 may be surrounded by the gap-fill insulating region G1 of the gap-fill insulating film 202. For example, the sidewalls of the first capping portion 212a_1 may contact the source/drain barrier layer 132 and the source/drain body layer 134, sidewalls of the second capping portion 212a_2 may contact the gap-fill insulating region G1 of the gap-fill insulating film 202, and an upper surface of the second capping portion 212a_2 may contact a lower surface of the source/drain barrier layer 132. The first capping portion 212a_1 may be a portion that protrudes from the second capping portion 212a_2 toward the source/drain body layer 134, an upper surface of the second capping portion 212a_2 may be covered and overlapped by the first capping portion 212a_1 and the source/drain barrier layer 132, and a lower surface of the second capping portion 212a_2 may be covered and overlapped by the backside metal silicide film 222. Upper surfaces of each of the backside metal silicide film 222, the conductive barrier pattern 224, and the contact plug 226 may have a planar shape.

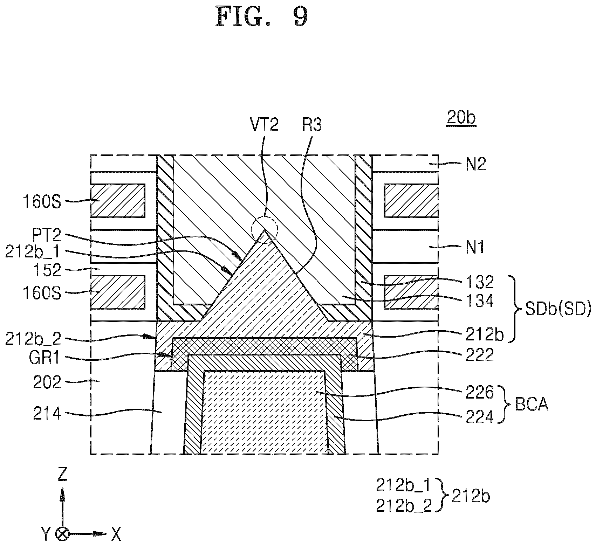

FIG. 9 is a diagram for explaining an integrated circuit device 20b according to other example embodiments. FIG. 9 shows a portion corresponding to the region EX3 in FIG. 6A.

Because the integrated circuit device 20a is configured generally and similarly to the integrated circuit device 20 described with reference to FIGS. 5, 6A, 6B, 6C, and 7, the differences from the integrated circuit device 20 are mainly described below. Redundant descriptions will not be repeated.

In example embodiments, the plurality of source/drain regions SD may include a first source/drain region SDa (see FIG. 6A) and a second source/drain region SDb. The first source/drain region SDa may be connected to the source/drain contact CA through the metal silicide film 172, and the second source/drain region SDb may be connected to the backside source/drain contact BCA through the backside metal silicide film 222.

In example embodiments, the second source/drain region SDb may include the source/drain barrier layer 132, the source/drain body layer 134 and a backside source/drain capping layer 212b below the source/drain body layer 134. The backside source/drain capping layer 212b may be disposed in the backside source/drain recess R3 recessed inward from a lower surface of the second source/drain region SDb. The backside source/drain capping layer 212b may penetrate a portion of the source/drain barrier layer 132 and the source/drain body layer 134.

The backside source/drain capping layer 212b may include a first capping portion 212b_1 that overlaps the source/drain barrier layer 132 and the source/drain body layer 134 in the first horizontal direction (e.g., the X direction), and a second capping portion 212b_2 that does not overlap the source/drain barrier layer 132 and the source/drain body layer 134 in the first horizontal direction (e.g., the X direction). The first capping portion 212b_1 may include a pointed portion PT2.

Sidewalls of the first capping portion 212b_1 may be surrounded by the source/drain barrier layer 132 and the source/drain body layer 134, and sidewalls of the second capping portion 212b_2 may be surrounded by the gap-fill insulating region G1 of the gap-fill insulating film 202. For example, the sidewalls of the first capping portion 212b_1 may contact the source/drain barrier layer 132 and the source/drain body layer 134, sidewalls of the second capping portion 212b_2 may contact the gap-fill insulating region G1 of the gap-fill insulating film 202, and an upper surface of the second capping portion 212b_2 may contact a lower surface of the source/drain barrier layer 132. The first capping portion 212b_1 may be a portion that protrudes from the second capping portion 212b_2 toward the source/drain body layer 134, and an upper surface of the second capping portion 212b_2 may be covered and overlapped by the first capping portion 212b_1 and the source/drain barrier layer 132.

The second capping portion 212b_2 may include a groove GR1 recessed from a lower surface to an inside thereof. A backside metal silicide film 222 may be disposed on the groove GR1. In some embodiments, the second capping portion 212b_2 may overlap the backside metal silicide film 222 in the first horizontal direction (e.g., the X direction). Also, in some embodiments, the second capping portion 212b_2 may overlap a portion of the backside source/drain contact BCA disposed in the backside metal silicide film 222 in the first horizontal direction (e.g., the X direction). Due to the groove GR1, a contact area between the backside source/drain capping layer 212b and the backside metal silicide film 222 may be relatively increased.

A backside insulating liner 214 may be disposed on the backside source/drain capping layer 212b and the backside metal silicide film 222. For example, an upper surface of the backside insulating liner 214 may contact lower surfaces of the backside source/drain capping layer 212b and the backside metal silicide film 222. The backside insulating liner 214 may be disposed between the backside source/drain contact BCA and the gap-fill insulating region G1 of the gap-fill insulating film 202. In example embodiments, the backside insulating liner 214 may include an oxide film, a nitride film, an ultra-low k (ULK) film having an ultra-low dielectric constant K in a range from about 2.2 to about 2.4, or any combination thereof. For example, the backside insulating liner 214 may include a tetraethylorthosilicate (TEOS) film, a high density plasma (HDP) oxide film, a boro-phospho-silicate glass (BPSG) film, a flowable chemical vapor deposition (FCVD) oxide film, a SiON film, a SiN film, a SiOC film, a SiCOH film, or any combination thereof but is not limited thereto.

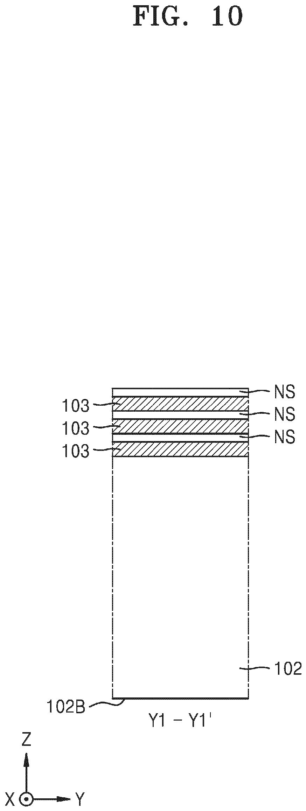

FIGS. 10, 11, 12A, 12B, 13, 14A, 14B, 15, 16, 17, 18A, 18B, 19A, 19B, 20A, 20B, 21A, 21B, 22A, and 22B are diagrams showing a process sequence of a method of manufacturing the integrated circuit device 10 according to example embodiments.

Specifically, FIGS. 10, 11, 12B, 13, 14B, 18B, 19B, 20B, 21B, and 22B are diagrams corresponding to the cross-section along line Y1-Y1' in FIG. 2, and FIGS. 12A, 14A, 15, 16, 17, 18A, 19A, 20A, 21A, and 22A are views corresponding to a cross-section along line X1-X1' in FIG. 2.

Like reference numerals in FIGS. 2, 3A, 3B, and 4 indicate like members, and detailed descriptions thereof are not repeated.

Referring to FIG. 10, a plurality of sacrificial semiconductor layers 103 and a plurality of nanosheet semiconductor layers NS may be alternately stacked one layer at a time on the substrate 102. The substrate 102 may include a semiconductor such as Si or Ge, or a compound semiconductor such as SiGe, SiC, GaAs, InAs, InGaAs, or InP. The terms "SiGe", "SiC", "GaAs", "InAs", "InGaAs", and "InP" used in the present specification refer to materials composed of elements included in each term and are not chemical formulas representing stoichiometric relationships. For example, substrate 102 may include a bulk Si substrate.

The plurality of sacrificial semiconductor layers 103 and the plurality of nanosheet semiconductor layers NS may include semiconductor materials having different etch selectivities from each other. In exemplary embodiments, the plurality of nanosheet semiconductor layers NS may include an Si layer, and the plurality of sacrificial semiconductor layers 103 may include a SiGe film. In example embodiments, a Ge content within the plurality of sacrificial semiconductor layers 103 may be constant. The SiGe film constituting the plurality of sacrificial semiconductor layers 103 may have a constant Ge content selected within a range of about 5 atomic% to about 60 atomic%, for example, about 10 atomic% to about 40 atomic%. The Ge content in the SiGe film constituting the plurality of sacrificial semiconductor layers 103 may be selected in various ways as needed.

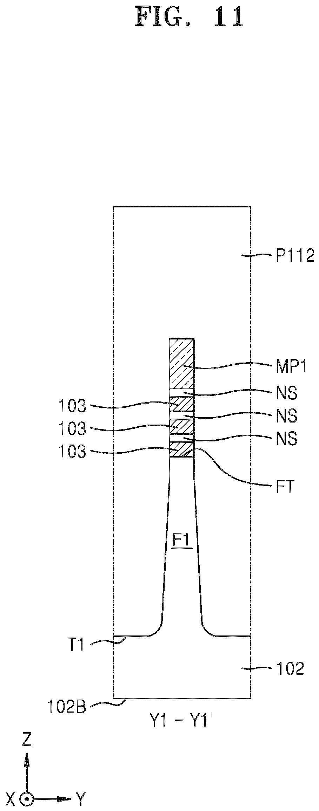

Referring to FIG. 11, after forming a mask pattern MP1 on the resultant product of FIG. 10, a fin-type active region F1 may be formed on the substrate 102 by etching a portion of the plurality of sacrificial semiconductor layers 103, the plurality of nanosheet semiconductor layers NS, and the substrate 102 using the mask pattern MP1 as an etch mask. A plurality of trench regions T1 may be defined on the substrate 102 by the fin-type active region F1. In example embodiments, the mask pattern MP1 may have a stacked structure of an oxide film pattern and a silicon nitride film pattern. The mask patterns MP1 may extend parallel to each other in the first horizontal direction (e.g., the X direction) on the substrate 102. A stacked structure of a plurality of sacrificial semiconductor layers 103 and a plurality of nanosheet semiconductor layers NS may remain on an upper surface of each fin of the fin-type active region F1.

A device isolation insulating film P112 (or referred to as "a device isolation insulating layer") may be formed on the obtained resultant product. The device isolation insulating film P112 may be formed to a thickness sufficient to fill remaining spaces of the plurality of trench regions T1 on a top of the substrate 102. The device isolation insulating film P112 may include a silicon oxide film.

To form the device isolation insulating film P112, a process, such as plasma enhanced chemical vapor deposition (PECVD), high density plasma CVD (HDP CVD), inductively coupled plasma CVD (ICP CVD), capacitor coupled plasma CVD (CCP CVD), flowable Chemical vapor deposition (FCVD), spin coating, etc. may be used.

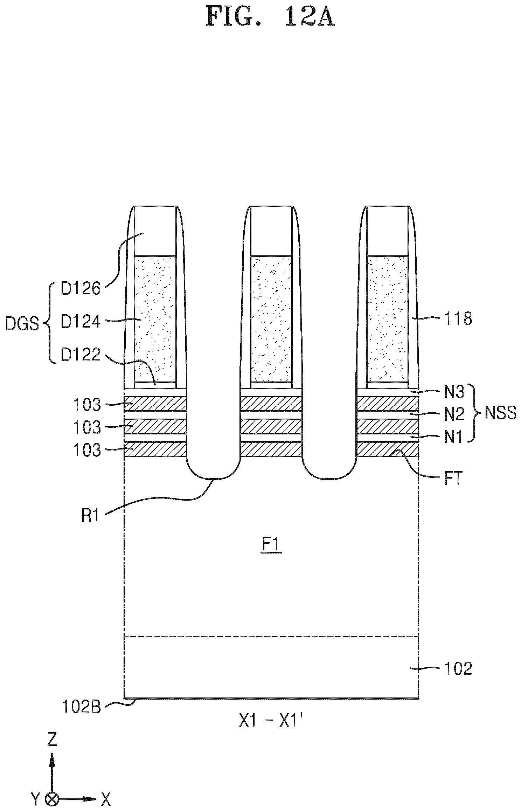

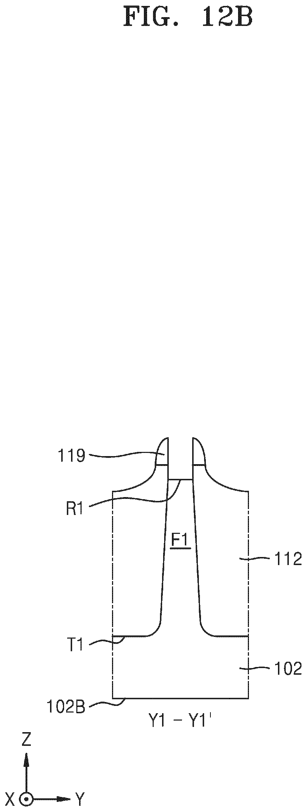

Referring to FIGS. 12A and 12B, after planarizing the resultant product of FIG. 11 so that an upper surface of the mask pattern MP1 is exposed, the exposed mask pattern MP1 is removed, and then, a device isolation film 112 may be formed by performing a recess process for removing a portion of the device isolation insulating film P112. As a result, the plurality of sacrificial semiconductor layers 103 and the plurality of nanosheet semiconductor layers NS (see FIG. 11) may protrude onto an upper surface of the device isolation film 112.

To perform the recess process of the device isolation insulating layer P112, dry etching, wet etching, or a combination of dry and wet etching processes may be used. At this time, a wet etching process using NH₄OH, tetramethyl ammonium hydroxide (TMAH), potassium hydroxide (KOH), etc. as an etchant, or a dry etching process, such as inductively coupled plasma (ICP), transformer coupled plasma (TCP), electron cyclotron resonance (ECR), reactive ion etch (RIE) may be used. If the recess process of the device isolation insulating film P112 is performed using a dry etching process, a fluorine-including gas such as CF₄, a chlorine-including gas such as Cl₂, HBr, etc. may be used as an etching gas.

A plurality of dummy gate structures DGS may be formed on a stacked structure of the plurality of sacrificial semiconductor layers 103 and the plurality of nanosheet semiconductor layers NS. Each of the plurality of dummy gate structures DGS may be formed to extend lengthwise in the second horizontal direction (e.g., the Y direction). Each of the plurality of dummy gate structures DGS may have a structure in which an oxide film D122, a dummy gate layer D124, and a capping layer D126 are sequentially stacked. In example embodiments, the oxide film D122 may be a film obtained by oxidizing surfaces of each of the plurality of sacrificial semiconductor layers 103 and the plurality of nanosheet semiconductor layers NS (see FIGS. 12A and 12B). The dummy gate layer D124 may include polysilicon, and the capping layer D126 may include a silicon nitride film.

After forming a plurality of outer insulating spacers 118 that cover and overlap both sidewalls of each of the plurality of dummy gate structures DGS, a portion of each of the plurality of sacrificial semiconductor layers 103 and the plurality of nanosheet semiconductor layers NS are etched using the plurality of dummy gate structures DGS and the plurality of outer insulating spacers 118 as an etch mask to divide the plurality of nanosheet semiconductor layers NS into a plurality of nanosheet stacks NSS each including a first nanosheet N1, a second nanosheet N2, and a third nanosheet N3. To etch a portion of each of the plurality of sacrificial semiconductor layers 103 and the plurality of nanosheet semiconductor layers NS, dry etching, wet etching, or any combination thereof may be used.

Thereafter, a plurality of active region recesses R1 may be formed by etching a portion of the exposed fin-type active region F1 exposed by etching the portion of each of the plurality of sacrificial semiconductor layers 103 and the plurality of nanosheet semiconductor layers NS. To form a plurality of active region recesses R1, etching may be performed by using dry etching, wet etching, or any combination thereof. After the plurality of active region recesses R1 are formed, a plurality of recess-side insulating spacers 119 disposed adjacent to the plurality of active region recesses R1 may be formed on the device isolation film 112.

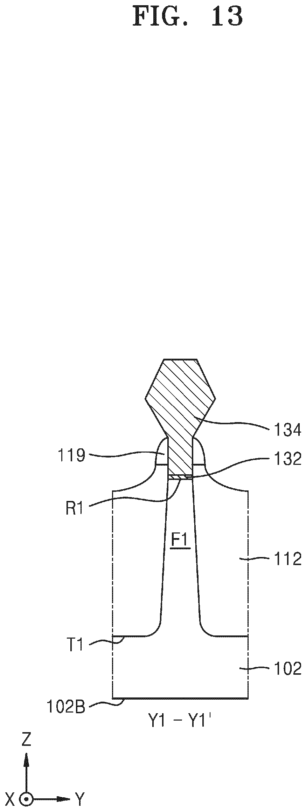

Referring to FIG. 13, a plurality of source/drain regions SD may be formed on the plurality of active region recesses R1.

To form the plurality of source/drain regions SD, the source/drain barrier layer 132 and the source/drain body layer 134 may be sequentially formed. The source/drain barrier layer 132 may be formed by epitaxially growing a semiconductor material from a surface of the fin-type active region F1 exposed from the bottom of the plurality of active region recesses R1 and sidewalls of each of the first nanosheet N1, the second nanosheet N2, and the third nanosheet N3 included in the nanosheet stack NSS, and the source/drain body layer 134 may be formed by epitaxially growing a semiconductor material from the source/drain barrier layer 132.

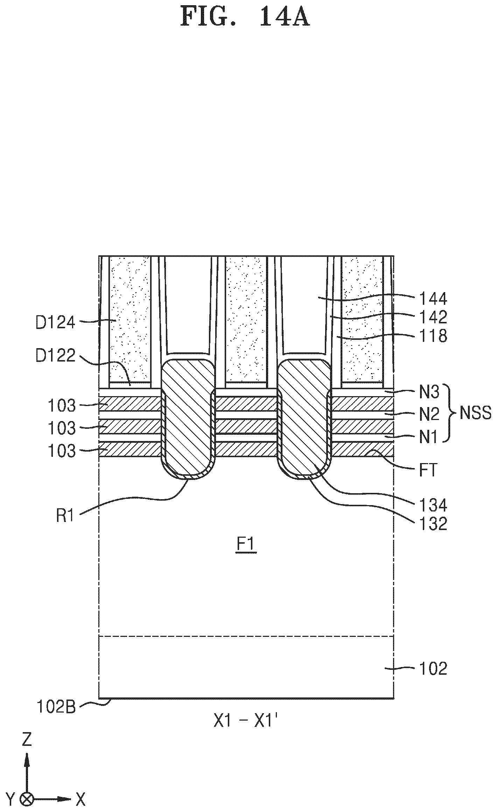

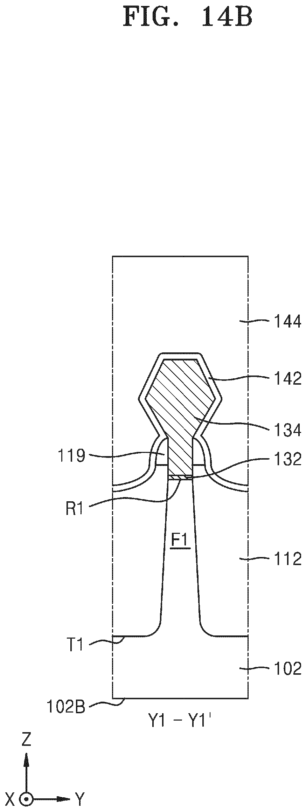

Referring to FIGS. 14A and 14B, after forming an insulating liner 142 cover and overlapping the resultant product of FIG. 13 and forming an inter-gate insulating film 144 on the insulating liner 142, a portion of each of the insulating liner 142 and the inter-gate insulating film 144 may be etched to expose an upper surface of the plurality of capping layers D126. Thereafter, the plurality of capping layers D126 are removed to expose the dummy gate layer D124, and a portion of each of the insulating liner 142 and the inter-gate insulating film 144 may be removed so that an upper surface of the inter-gate insulating film 144 and an upper surface of the dummy gate layer D124 are at approximately the same level.

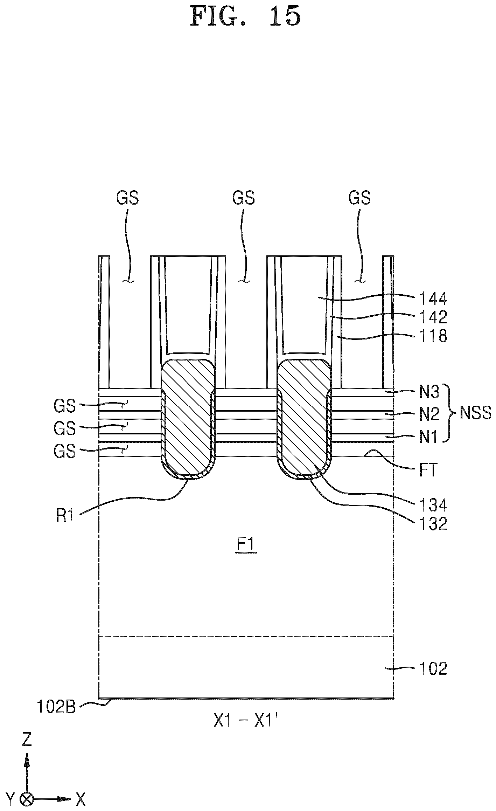

Referring to FIG. 15, a gate space GS may be prepared by removing the dummy gate layer D124 and the oxide film D122 below the dummy gate layer D124 from the resultant product of FIGS. 14A and 14B, and the plurality of nanosheet stack NSS may be exposed through the gate space GS. Thereafter, the plurality of sacrificial semiconductor layers 103 remaining on the fin-type active region FA are removed through the gate space GS, and the gate space GS may be extended into a space between each of the first nanosheet N1, the second nanosheet N2, and the third nanosheet N3 and a space between the first nanosheet N1 and the fin upper surface FT. In example embodiments, to selectively remove the plurality of sacrificial semiconductor layers 103, a difference in etch selectivity between the first nanosheet N1, the second nanosheet N2, and the third nanosheet N3 and the plurality of sacrificial semiconductor layers 103 may be used.

A liquid or vapor phase etchant may be used to selectively remove the plurality of sacrificial semiconductor layers 103. In example embodiments, a CH₃COOH-based etchant, for example, an etchant including a mixture of CH₃COOH, HNO₃, and HF or an etchant including a mixture of CH₃COOH, H₂O₂, and HF may be used to selectively remove the plurality of sacrificial semiconductor layers 103, but the etchant is not limited to the above examples.

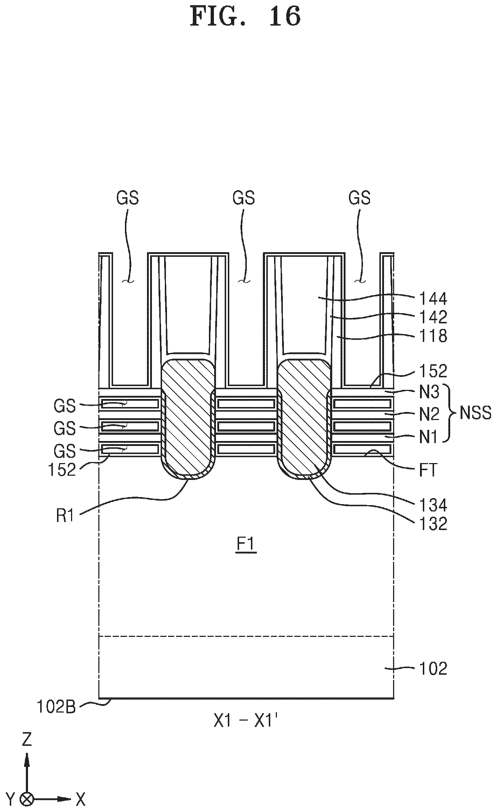

Referring to FIG. 16, in the resultant product of FIG. 15, a gate dielectric film 152 may cover and overlap exposed surfaces of each of the first nanosheet N1, the second nanosheet N2, the third nanosheet N3, and the fin-type active region F1. To form the gate dielectric film 152, an atomic layer deposition (ALD) process may be used.

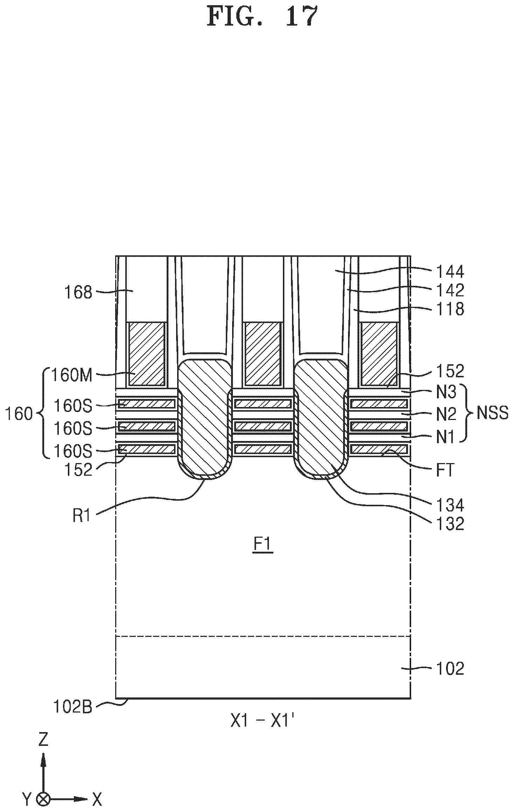

Referring to FIG. 17, on the gate dielectric film 152, a gate line 160 filling the gate space GS (see FIG. 16) and covering and overlapping the upper surface of the inter-gate insulating film 144 and a capping insulating pattern 168 covering and overlapping an upper surface of each of the gate line160 and the gate dielectric film 152 in the gate space GS may be formed.

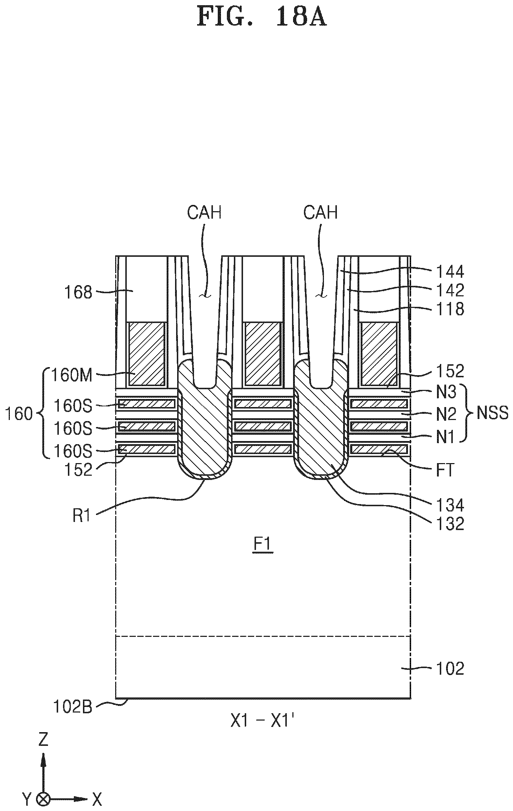

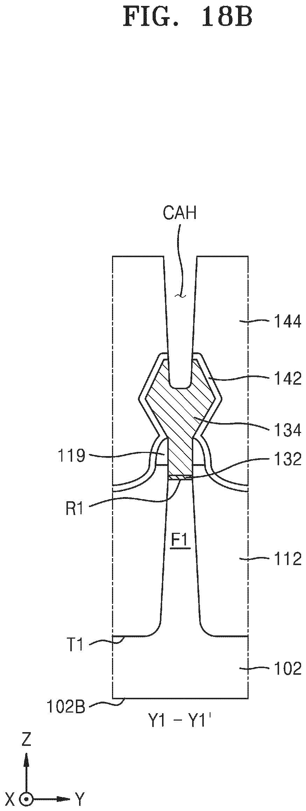

Referring to FIGS. 18A and 18B, in the resultant product of FIG. 17, a plurality of source/drain contact holes CAH may be formed to expose the plurality of source/drain regions SD through an insulating structure including the insulating liner 142 and the inter-gate insulating film 144. Some regions of the plurality of source/drain regions SD may be removed through the source/drain contact holes CAH by using an anisotropic etching process so that the plurality of source/drain contact holes CAH may extend longer toward the substrate 102.

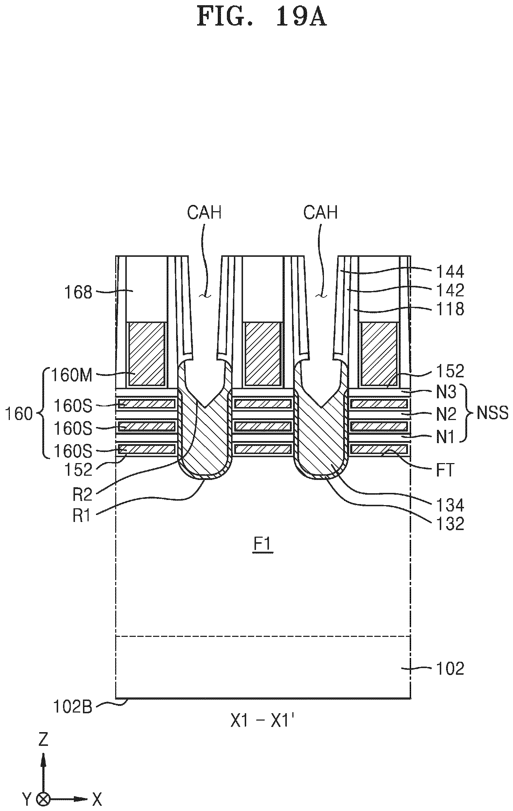

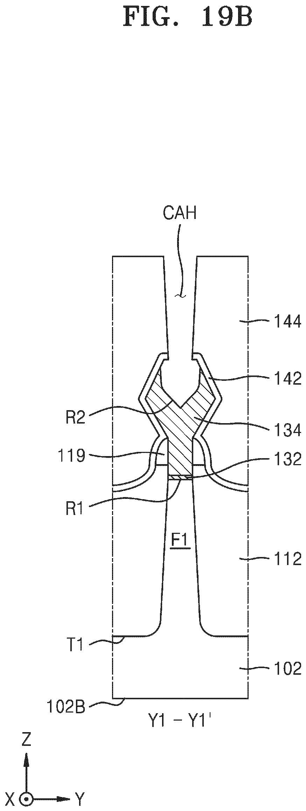

Referring to FIGS. 19A and 19B, some regions of the source/drain regions SD exposed through the plurality of source/drain contact holes CAH of FIGS. 18A and 18B may be removed through an anisotropic etching process. For example, the etching process may include a dry etching process, or may include a reactive ion etching (RIE) process or an atomic layer etching (ALE) process. The etching process may use a chlorine-including gas such as Cl₂ as an etching gas. Before and after the etching process, a cleaning process may be performed using a carbon (C)-including gas or an oxygen (O)-including gas. Through the etching process, a source/drain recess R2 having a pointed shape toward the substrate 102 may be formed.

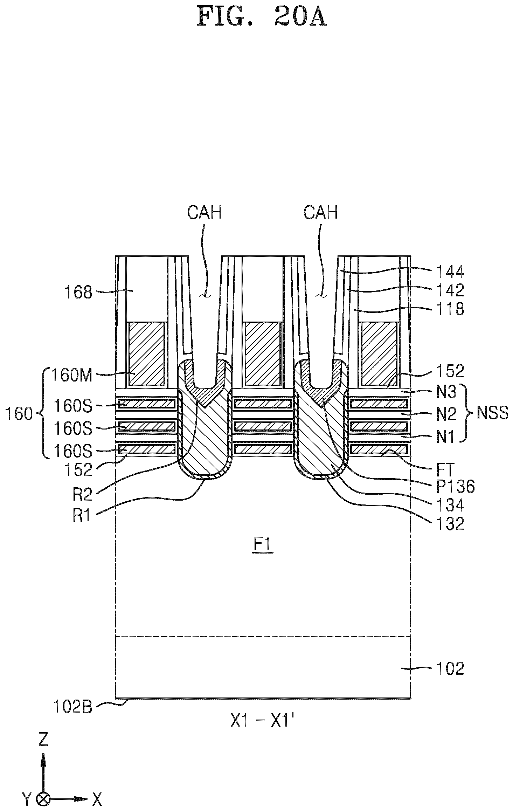

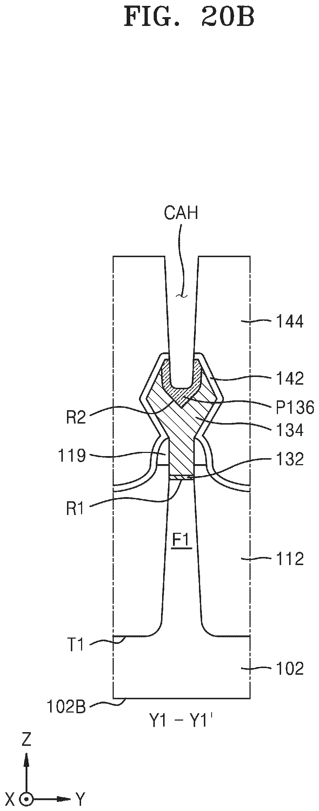

Referring to FIGS. 20A and 20B, a preliminary source/drain capping layer P136 may be formed on the source/drain recess R2 of FIGS. 19A and 19B. The preliminary source/drain capping layer P136 is formed by epitaxially growing a semiconductor material on the source/drain barrier layer 132 and/or source/drain body layer 134 exposed through the source/drain recess R2. Because the source/drain recess R2 includes a pointed shape, the weakness of adhesion due to mismatch in lattice constant between the source/drain barrier layer 132 and/or the source/drain body layer 134 and the preliminary source/drain capping layer P136 may be reduced at an interface between the source/drain barrier layer 132 and/or the source/drain body layer 134 and the preliminary source/drain capping layer P136.

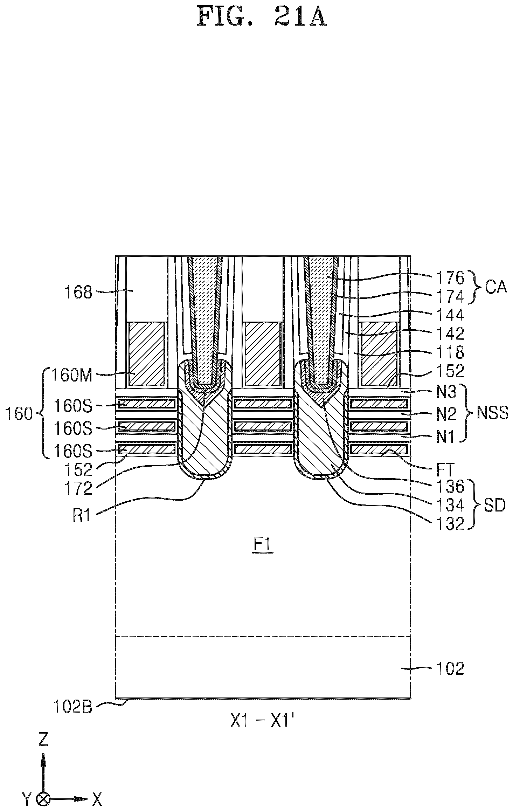

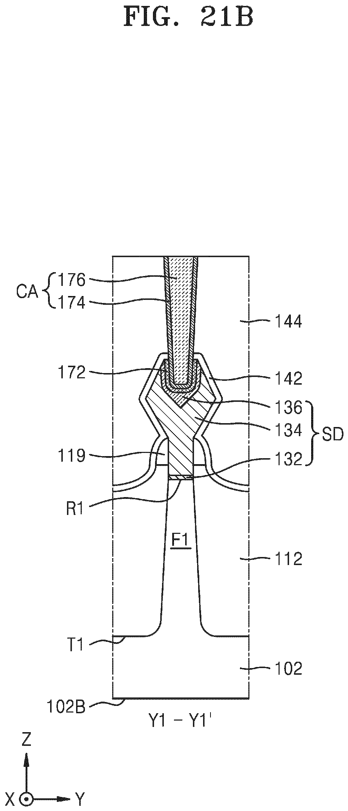

Referring to FIGS. 21A and 21B, a portion of the preliminary source/drain capping layer P136 of FIGS. 20A and 20B may be consumed to form a metal silicide film 172. In example embodiments, to form the metal silicide film 172, a process of forming a metal liner (not shown) conformally covering and overlapping an exposed surface of the preliminary source/drain capping layer P136 and a process of inducing a reaction between the preliminary source/drain capping layer P136 and a metal constituting the metal liner by heat treating the metal liner may be included. After the metal silicide film 172 is formed, a remaining portion of the metal liner may be removed. In example embodiments, if the metal silicide film 172 includes a titanium silicide film, the metal liner may include a Ti film.

Thereafter, a source/drain contact CA including a conductive barrier pattern 174 and a contact plug 176 may be formed on the metal silicide film 172.

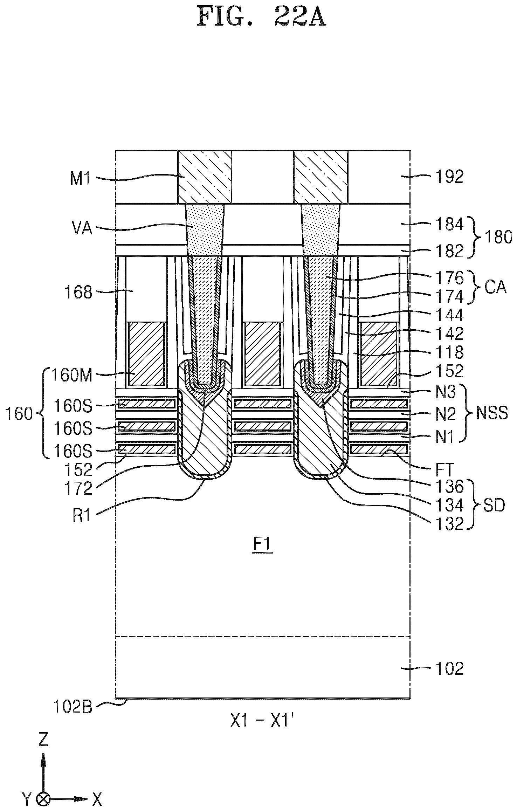

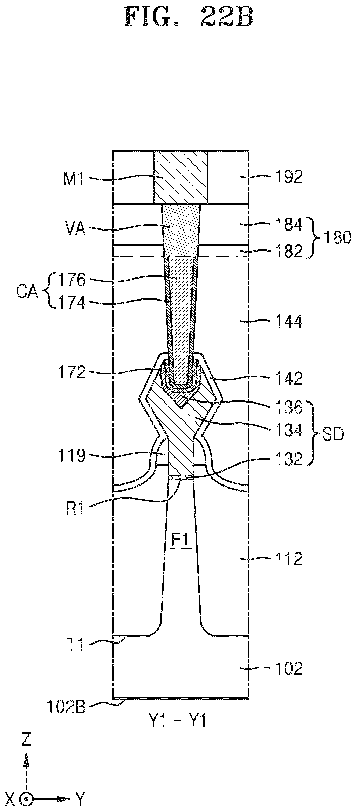

Referring to FIGS. 22A and 22B, in the resultant products of FIGS. 21A and 21B, an upper insulating structure 180 may be formed by sequentially forming an etch stop film 182 and an interlayer insulating film 184 covering and overlapping upper surfaces of each of the inter-gate insulating film 144, the plurality of source/drain contacts CA, and the plurality of capping insulating patterns 168, and a plurality of source/drain via contacts VA may be formed to be connected to the plurality of source/drain contacts CA through the upper insulating structure 180 in the vertical direction (e.g., the Z direction).

Thereafter, an upper insulating film 192 covering and overlapping upper surfaces of the upper insulating structure 180 and each of the plurality of source/drain via contacts VA may be formed, and a plurality of upper wiring layers M1 may be formed to be connected to the plurality of source/drain via contacts VA through the upper insulating film 192 in the vertical direction (e.g., the Z direction).

FIG. 23A, FIG. 23B, FIG. 24A, FIG. 24B, FIG. 25A, FIG. 25B, FIG. 25C, FIG. 26A, FIG. 26B, FIG. 27A, FIG. 27B, FIG. 28A, FIG. 28B, FIG. 29A, FIG. 29B, FIG. 29C, FIG. 30A, FIG. 30B, FIG. 31A, FIG. 31B, FIG. 32A, FIG. 32B, FIG. 33A, FIG. 33B, FIG. 34A, FIG. 34B, FIG. 35A, and FIG. 35B are diagrams showing a process sequence of a method of manufacturing the integrated circuit device 20 according to other example embodiments.

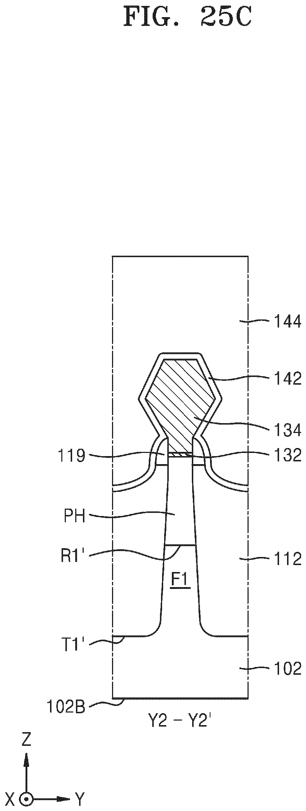

Specifically, FIG. 23A, FIG. 24A, FIG. 25A, FIG. 26A, FIG. 27A, FIG. 28A, FIG. 29A, FIG. 30A, FIG. 31A, FIG. 32A, FIG. 33A, FIG. 34A, and FIG. 35A are diagrams corresponding to the cross-section along line X1-X1' in FIG. 5. FIG. 23B, FIG. 24B, FIG. 25B, FIG. 26B, FIG. 27B, FIG. 28B, and FIG. 29B are diagrams corresponding to the cross-section along line Y1-Y1' in FIG. 5. FIG. 25C, FIG. 29C, FIG. 30B, FIG. 31B, FIG. 32B, FIG. 33B, FIG. 34B, and FIG. 35B are diagrams corresponding to the cross-section along line Y2-Y2' in FIG. 5.

The same reference numerals as in FIGS. 5, 6A, 6B, 6C, and 7 indicate the same members, and detailed description thereof will not be repeated.

Referring to FIGS. 23A and 23B, after the processes described above with reference to FIGS. 10 and 11 are performed, the resultant product of FIG. 11 is planarized so that an upper surface of the mask pattern MP1 is exposed and the exposed mask pattern MP1 is removed, and then, a device isolation film 112 may be formed by performing a recess process for removing a portion of the device isolation insulating film P112. As a result, a plurality of sacrificial semiconductor layers 103 and a plurality of nanosheet semiconductor layers NS (see FIG. 11) may protrude onto an upper surface of the device isolation film 112.

To perform a recess process for removing the device isolation insulating layer P112, dry etching, wet etching, or a combination thereof may be used. At this time, a wet etching process using NH₄OH, TMAH, KOH, etc. as an etchant, or a dry etching process, such as ICP, TCP, ECR, RIE may be used. If the recess process of the device isolation insulating film P112 is performed using a dry etching process, a fluorine-including gas such as CF₄, a chlorine-including gas such as Cl₂, HBr, etc. may be used as an etching gas.

A plurality of dummy gate structures DGS may be formed on a stacked structure of the plurality of sacrificial semiconductor layers 103 and the plurality of nanosheet semiconductor layers NS. Each of the plurality of dummy gate structures DGS may be formed to extend lengthwise in the second horizontal direction (e.g., the Y direction). Each of the plurality of dummy gate structures DGS may have a structure in which an oxide film D122, a dummy gate layer D124, and a capping layer D126 are sequentially stacked. In example embodiments, the oxide film D122 may be a film obtained by oxidizing surfaces of each of the plurality of sacrificial semiconductor layers 103 and the plurality of nanosheet semiconductor layers NS (see FIG. 12A). The dummy gate layer D124 may include polysilicon, and the capping layer D126 may include a silicon nitride film.

After forming a plurality of outer insulating spacers 118 that cover and overlap both sidewalls of each of the plurality of dummy gate structures DGS, a portion of each of the plurality of sacrificial semiconductor layers 103 and the plurality of nanosheet semiconductor layers NS are etched using the plurality of dummy gate structures DGS and the plurality of outer insulating spacers 118 as an etch mask to divide the plurality of nanosheet semiconductor layers NS into a plurality of nanosheet stacks NSS each including a first nanosheet N1, a second nanosheet N2, and a third nanosheet N3. To etch a portion of each of the plurality of sacrificial semiconductor layers 103 and the plurality of nanosheet semiconductor layers NS, dry etching, wet etching, or any combination thereof may be used.

Thereafter, a plurality of active region recesses R1 may be formed by etching a portion of the exposed fin-type active region F1 exposed by etching the portion of each of the plurality of sacrificial semiconductor layers 103 and the plurality of nanosheet semiconductor layers NS. To form a plurality of active region recesses R1, etching may be performed by using dry etching, wet etching, or any combination thereof. After the plurality of active region recesses R1 are formed, a plurality of recess-side insulating spacers 119 disposed adjacent to the plurality of active region recesses R1 may be formed on the device isolation film 112.

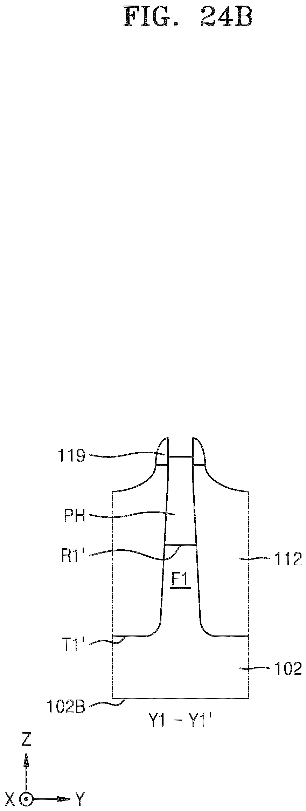

Referring to FIGS. 24A and 24B, a plurality of place holders PH may be formed on the plurality of active region recesses R1. In example embodiments, the plurality of place holders PH may include a SiGe film. For example, the plurality of place holders PH may include a single crystalline SiGe film, a polycrystalline SiGe film, an amorphous SiGe film, or any combination thereof.

In example embodiments, to form the plurality of place holders PH, various deposition processes, such as a PECVD process, an HDP CVD process, an ICP CVD process, a CCP CVD process, an FCVD process, etc. may be performed using raw materials including an elemental precursor. In other example embodiments, to form a plurality of place holders PH, an LPCVD process, an SEG process, or a CDE process may be performed using raw materials including an elemental semiconductor precursor. The elemental semiconductor precursor may include an Si source including an element Si. As the Si source, silane (SiH4), disilane (Si2H6), trisilane (Si3H8), dichlorosilane (SiH2Cl2), etc. may be used, but the Si source is not limited thereto. Also, the elemental semiconductor precursor may include a Ge source including an element Ge. As the Ge source, germane (GeH₄), digermaine (Ge₂H₆), trigermaine (Ge₃H₈), tetragermaine (Ge₄H₁₀), dichlorgermaine (Ge₂H₂Cl₂), etc. may be used, but the Ge source is not limited thereto. For example, the plurality of place holders PH may be formed by epitaxially growing a SiGe film from a surface of the fin-type active region F1 exposed at sidewalls and bottom of the active region recess R1. In this case, the plurality of place holders PH may include a single crystal SiGe film.

In example embodiments, the content of Ge in the plurality of place holders PH may be constant. The SiGe film constituting the plurality of place holders PH may have a constant Ge content selected within a range of about 5 atomic% to about 60 atomic%, for example, about 10 atomic% to about 40 atomic%. However, the Ge content in the SiGe film constituting the plurality of placeholders PH may be variably selected within a range so that an etch selectivity between the plurality of placeholders PH and the fin-type active region F1 is different.

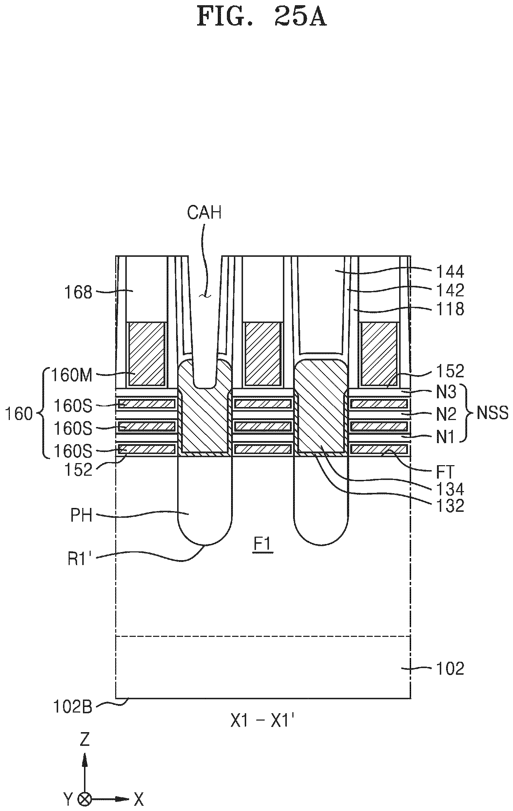

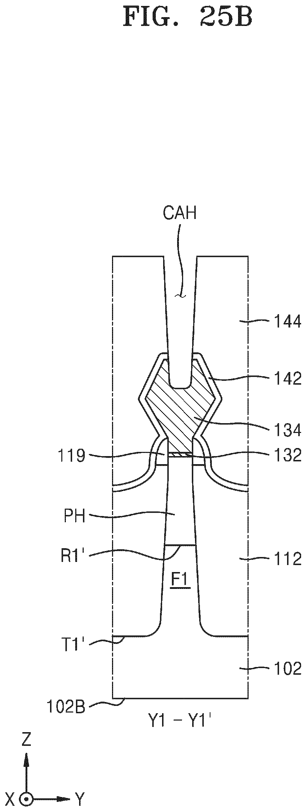

Referring to FIGS. 25A and 25B, a plurality of source/drain regions SD may be formed on the plurality of place holders PH.

To form the plurality of source/drain regions SD, the source/drain barrier layer 132 and the source/drain body layer 134 may be sequentially formed. The source/drain barrier layer 132 may be formed by epitaxially growing a semiconductor material from surfaces of the plurality of place holders PH and sidewalls of each of the first nanosheet N1, the second nanosheet N2, and the third nanosheet N3 included in the nanosheet stack NSS, and the source/drain body layer 134 may be formed by epitaxially growing a semiconductor material from the source/drain barrier layer 132.

Thereafter, an insulating liner 142, an inter-gate insulating film 144, a gate dielectric film 152, a gate line 160, and a capping insulating pattern 168 may be sequentially formed by performing the processes described with reference to FIGS. 14A and 14B, 15, 16, and 17.

Referring to FIGS. 25A, 25B, and 25C, in the resultant products of FIGS. 24A and 24B, a source/drain contact hole CAH that exposes a selected source/drain region SD among the plurality of source/drain regions SD through an insulating structure including the insulating liner 142 and the inter-gate insulating film 144 may be formed. The source/drain contact hole CAH may be formed to extend long toward the substrate 102 by removing a portion of the source/drain region SD using an anisotropic etching process through the source/drain contact hole CAH.

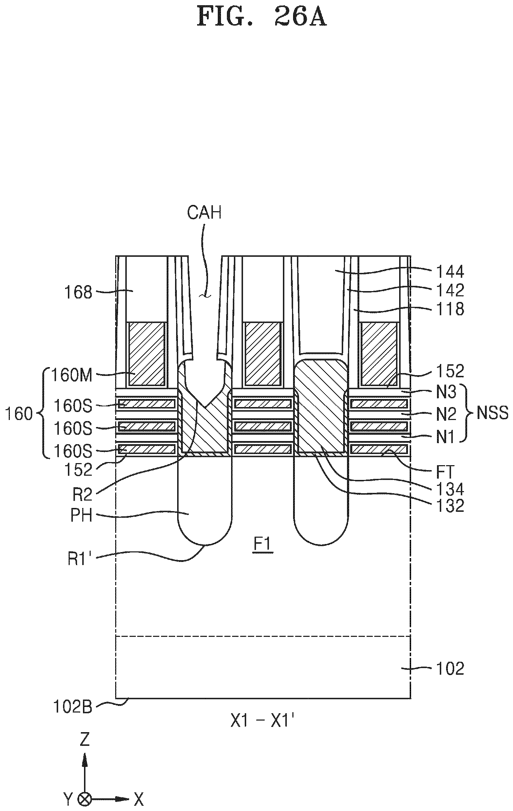

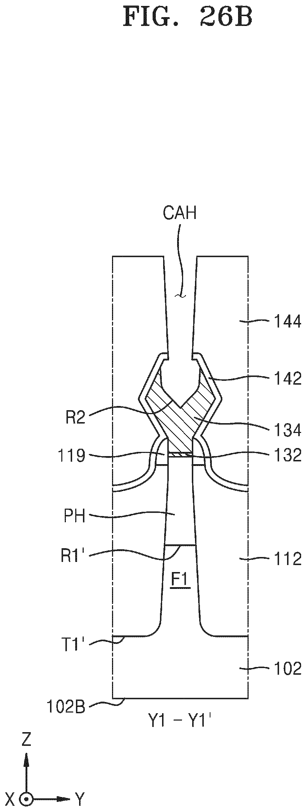

Referring to FIGS. 26A and 26B, a portion of the source/drain region SD exposed through the source/drain contact hole CAH of FIGS. 25A and 25B may be removed by using an anisotropic etching process. For example, the etching process may include a dry etching process, or may include an RIE process or an ALE process. The etching process may use a chlorine-including gas such as Cl₂ as an etching gas. Before and after the etching process, a cleaning process may be performed using a carbon (C)-including gas or an oxygen (O)-including gas. Through the etching process, a source/drain recess R2 having a pointed shape toward the substrate 102 may be formed.

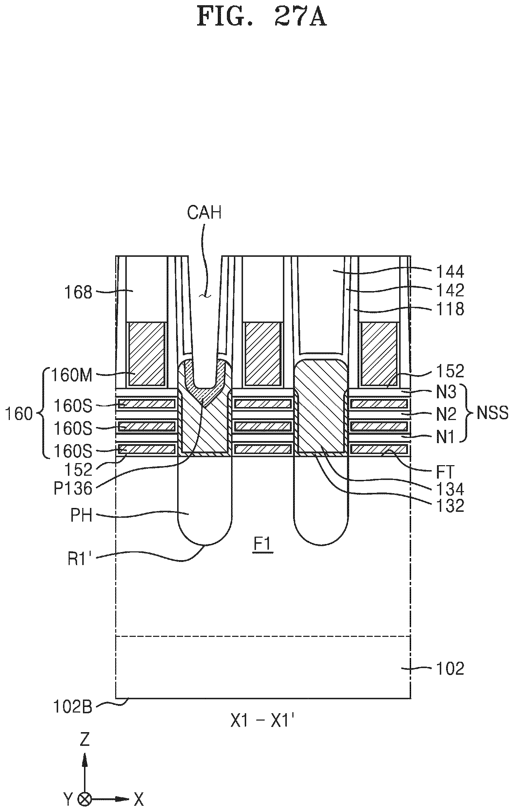

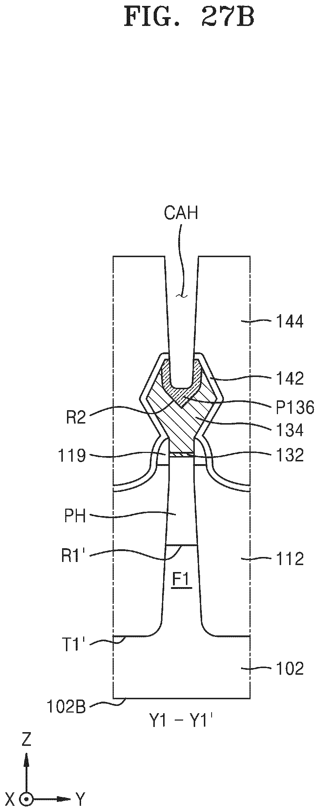

Referring to FIGS. 27A and 27B, a preliminary source/drain capping layer P136 may be formed on the source/drain recess R2 of FIGS. 26A and 26B. The preliminary source/drain capping layer P136 is formed by epitaxially growing a semiconductor material on the source/drain barrier layer 132 and/or source/drain body layer 134 exposed through the source/drain recess R2. Because the source/drain recess R2 includes a pointed shape, the reduction of adhesion force due to mismatch in lattice constant between the source/drain barrier layer 132 and/or the source/drain body layer 134 may be reduced at an interface between the source/drain barrier layer 132 and/or the source/drain body layer 134 and the preliminary source/drain capping layer P136.

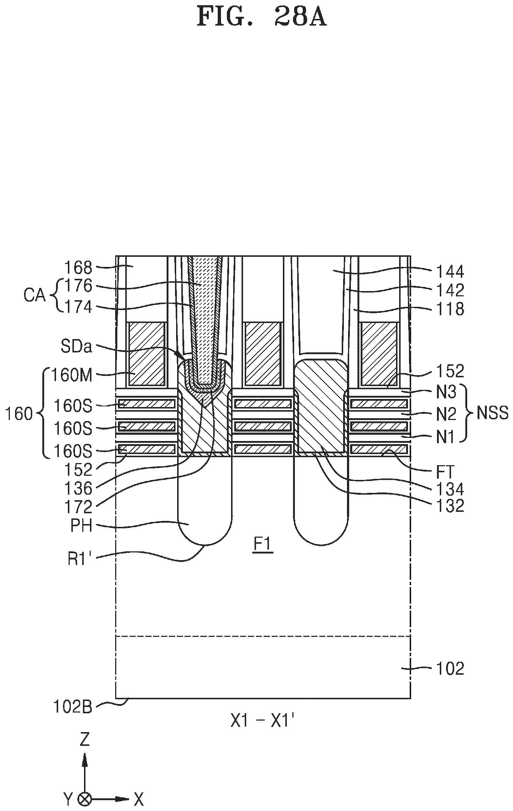

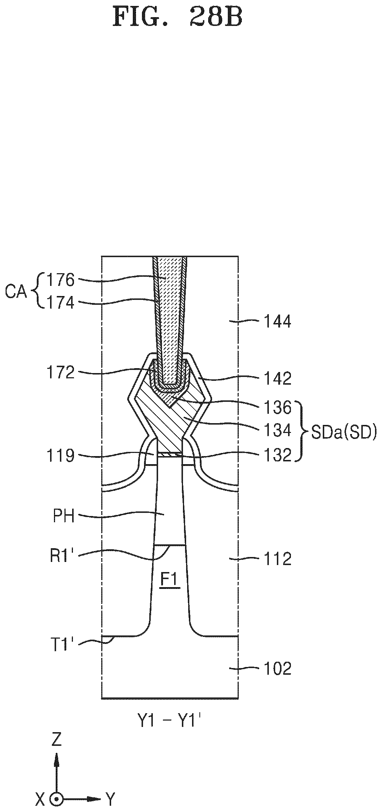

Referring to FIGS. 28A and 28B, a portion of the preliminary source/drain capping layer P136 of FIGS. 27A and 27B may be consumed to form a metal silicide film 172. In example embodiments, to form the metal silicide film 172, a process of forming a metal liner (not shown) conformally covering and overlapping an exposed surface of the preliminary source/drain capping layer P136 and a process of inducing a reaction between the preliminary source/drain capping layer P136 and a metal constituting the metal liner by heat treating the metal liner may be included. After the metal silicide film 172 is formed, a remaining portion of the metal liner may be removed.

Thereafter, a source/drain contact CA including a conductive barrier pattern 174 and a contact plug 176 may be formed on the metal silicide film 172.

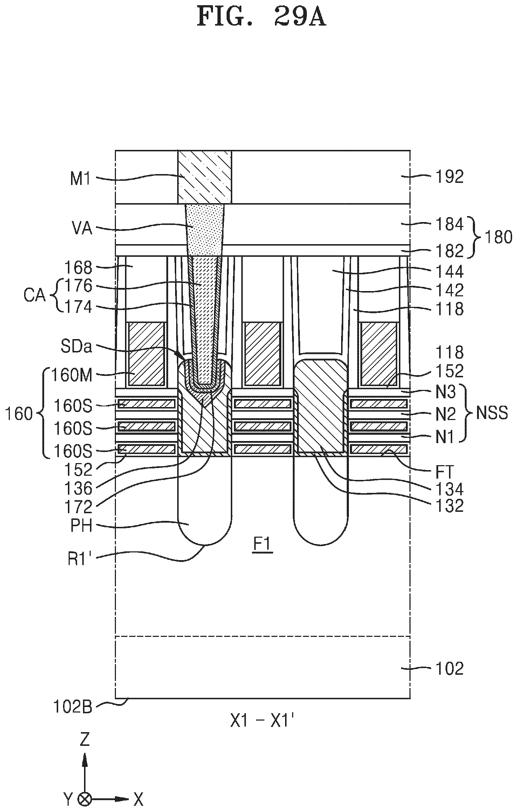

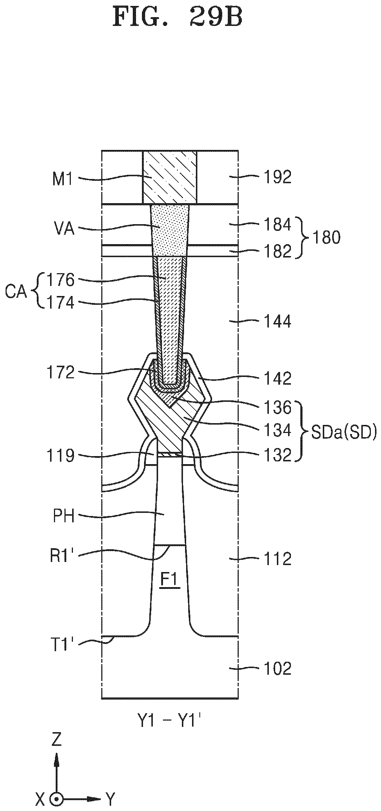

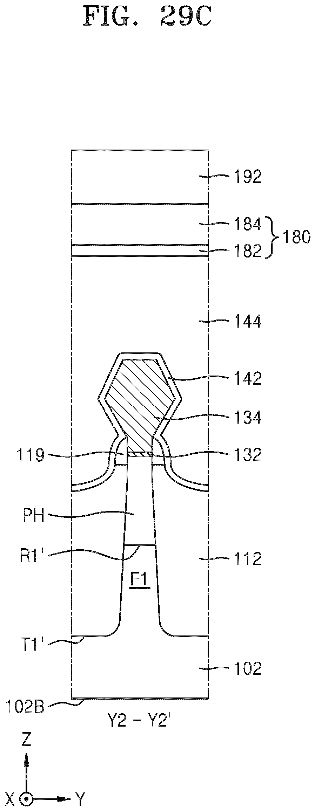

Referring to FIGS. 29A, 29B, and 29C, in the resultant products of FIGS. 28A and 28B, an upper insulating structure 180 may be formed by sequentially forming an etch stop film 182 and an interlayer insulating film 184 covering and overlapping upper surfaces of each of the inter-gate insulating film 144, the plurality of source/drain contacts CA, and the plurality of capping insulating patterns 168, and a plurality of source/drain via contacts VA may be formed to be connected to the plurality of source/drain contacts CA through the upper insulating structure 180 in the vertical direction (e.g., the Z direction).

Thereafter, an upper insulating film 192 covering and overlapping upper surfaces of the upper insulating structure 180 and each of the plurality of source/drain via contacts VA may be formed, and a plurality of upper wiring layers M1 may be formed to be connected to the plurality of source/drain via contacts VA through the upper insulating film 192 in the vertical direction (e.g., the Z direction).

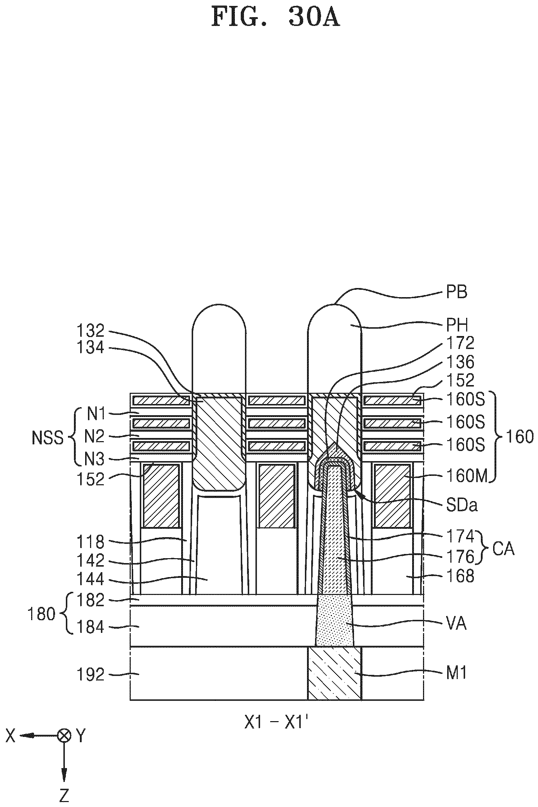

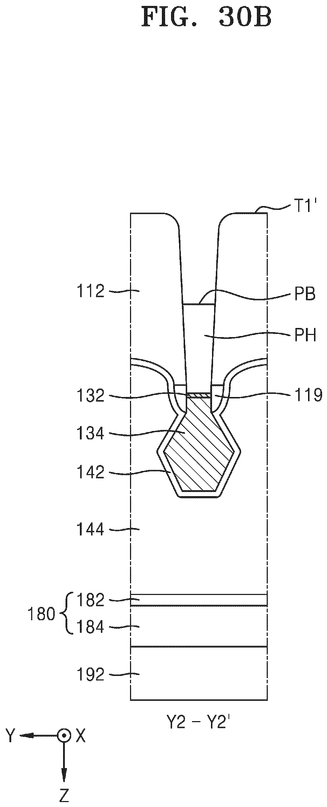

Referring to FIGS. 30A and 30B, the resultant products of FIGS. 29A, 29B, and 29C may be reversed so that a backside surface 102B of the substrate 102 is located on the upper side. Thereafter, a chemical mechanical polishing process may be performed on the backside surface 102B of the substrate 102 to expose the plurality of place holders PH.

Thereafter, the fin-type active region F1 surrounding the plurality of place holders PH may be selectively removed. To selectively remove the fin-type active region F1 surrounding the plurality of placeholders PH, a difference in etch selectivity between the fin-type active region F1 and the placeholder PH may be used. For example, to selectively remove the fin-type active region F1 surrounding the exposed place holder PH, an RIE process, a thermal etch process, or a wet etching process using a liquid or vapor phase etchant may be performed. For example, an etchant including TMAH may be used but is not limited thereto.

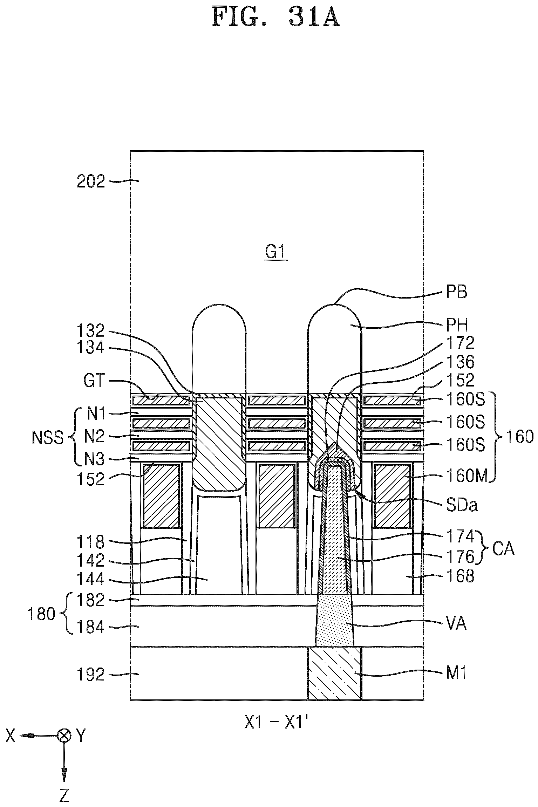

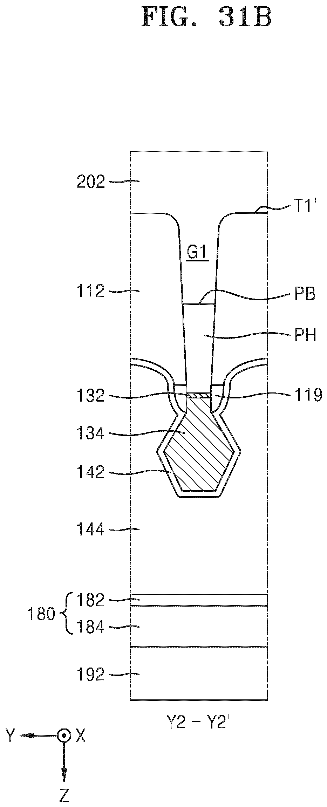

Referring to FIGS. 31A and 31B, a gap-fill insulating film 202 may be formed in a space formed by selectively removing the fin-type active region F1 (see FIGS. 29A, 29B, and 29C) on the resultant products of FIGS. 30A and 30B. To form the gap-fill insulating film 202, various methods, such as a PVD process, a CVD process, or an ALD process may be used. Thereafter, a chemical mechanical polishing process may be performed on an upper surface of the gap-fill insulating film 202 to planarize the upper surface of the gap-fill insulating film 202.

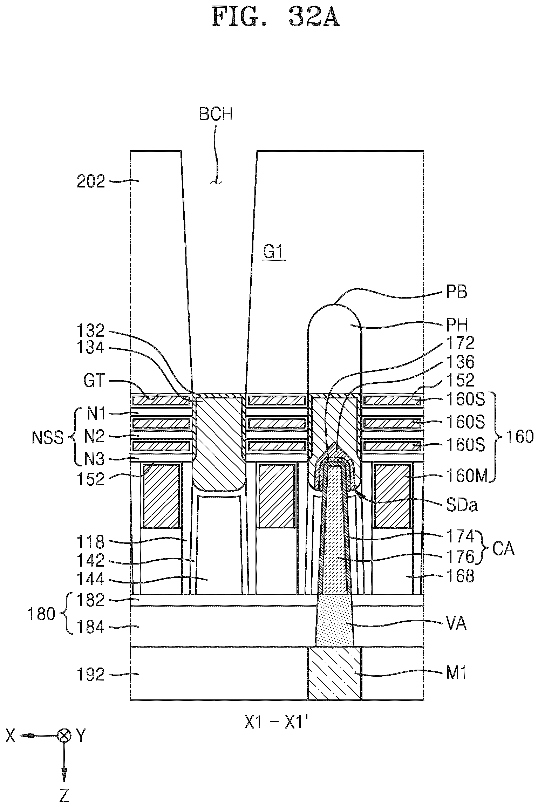

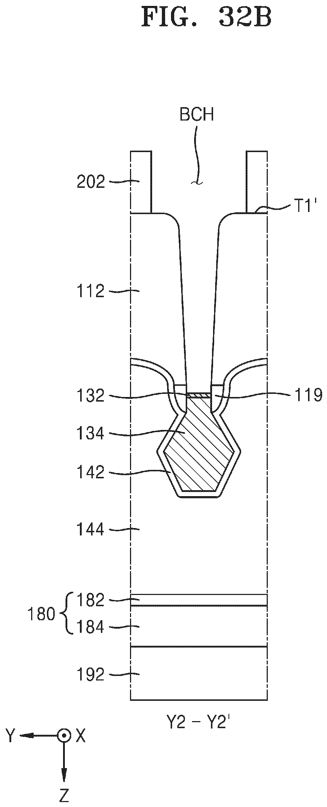

Referring to FIGS. 32A and 32B, a backside source/drain contact hole BCH may be formed by etching a portion of the gap-fill insulation region G1 of the gap-fill insulating film 202 on the resultant products of FIGS. 31A and 31B. A selected place holder PH among the plurality of place holders PH may be exposed through the backside source/drain contact hole BCH, and then, an etching process for removing the place holder PH may be performed through the backside source/drain contact hole BCH. An etching process for removing the place holder PH may include a selective etching process using the fact that the place holder PH includes a material different from that of the gap-fill insulating film 202. For example, an RIE process may be performed to remove a place holder PH.

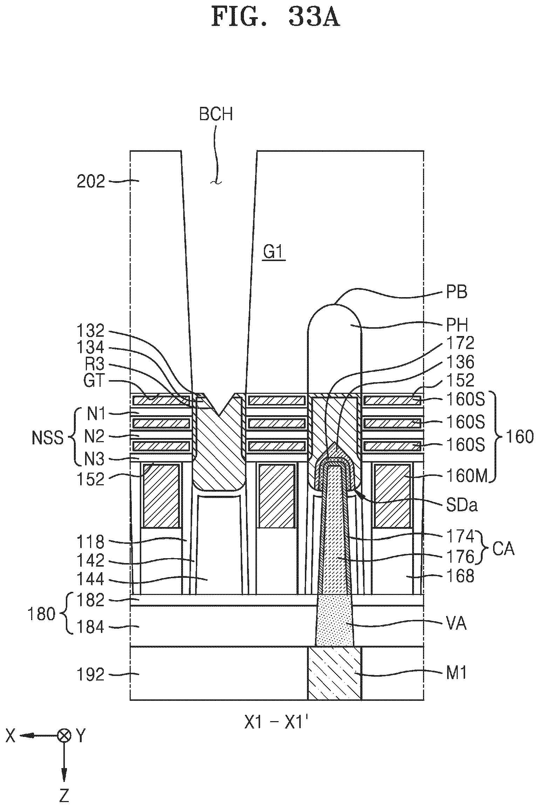

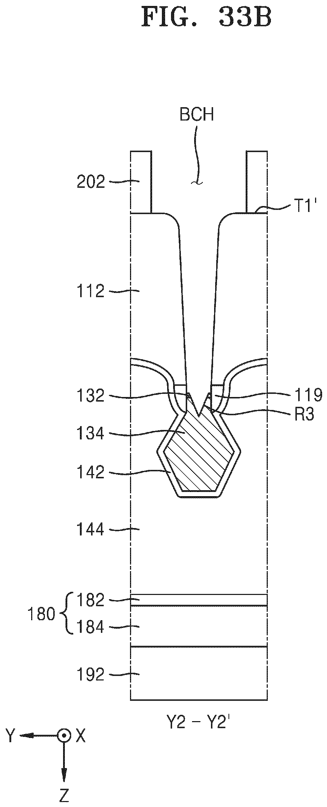

Referring to FIGS. 33A and 33B, a portion of the source/drain region SD exposed by removing the place holder PH through the backside source/drain contact hole BCH may be removed by an anisotropic etching process. For example, the etching process may include a dry etching process, or may include a method such as RIE or ALE. The etching process may use a chlorine-including gas such as Cl₂ as an etching gas. Before and after the etching process, a cleaning process may be performed using a carbon (C)-including gas or an oxygen (O)-including gas. Through the etching process, a backside source/drain recess R3 having a pointed shape toward the inter-gate insulating film 144 may be formed.

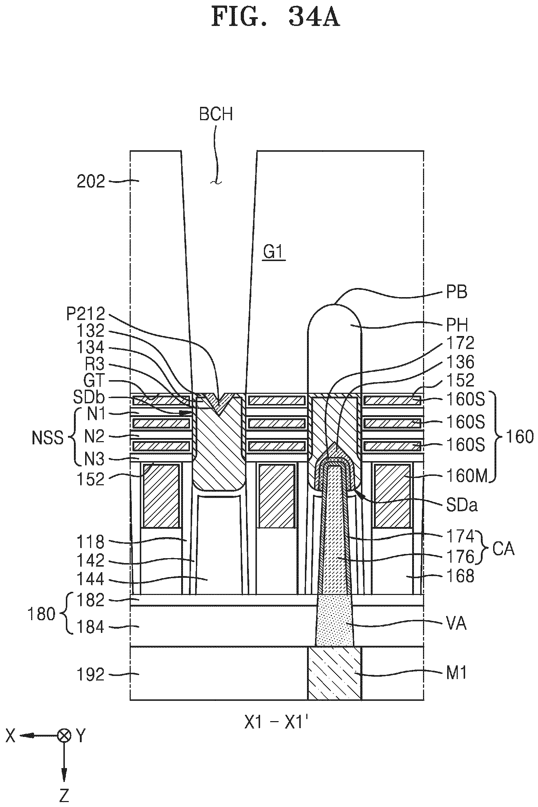

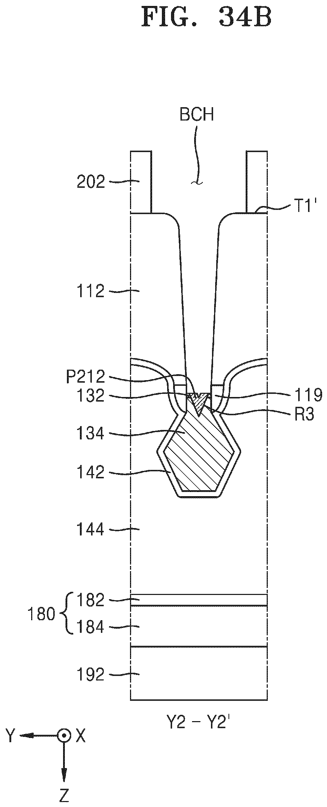

Referring to FIGS. 34A and 34B, a preliminary backside source/drain capping layer P212 may be formed on the backside source/drain recess R3 of FIGS. 33A and 33B. The preliminary backside source/drain capping layer P212 may be formed by epitaxially growing a semiconductor material on the source/drain barrier layer 132 and/or source/drain body layer 134 exposed through the backside source/drain recess R3. Because the source/drain recess R3 includes a pointed shape, the weakness of adhesion due to mismatch in lattice constant between the source/drain barrier layer 132 and/or the source/drain body layer 134 and the preliminary backside source/drain capping layer P212 may be reduced at an interface between the source/drain barrier layer 132 and/or the source/drain body layer 134 and preliminary backside source/drain capping layer P212.

In some other embodiments, the preliminary backside source/drain capping layer P212 may be formed relatively thick by epitaxially growing a semiconductor material until an upper surface of the source/drain barrier layer 132 exposed through the backside source/drain contact hole BC is covered and overlapped. In this case, like the integrated circuit device 20a described with reference to FIG. 8, the backside source/drain capping layer P212 may include a portion overlapping the gap-fill insulating region P1 of the gap-fill insulating film 202 in the first horizontal direction (e.g., the X direction).

In some other embodiments, after forming the preliminary backside source/drain capping layer P212 relatively thick by epitaxially growing a semiconductor material until an upper surface of the source/drain barrier layer 132 exposed through the backside source/drain contact hole BC is covered and overlapped, a backside insulating liner 214 (see in FIG. 9) may be conformally formed along sidewalls of the backside source/drain contact hole BCH, and a portion of the central region of the preliminary backside source/drain capping layer P212 may be etched. In this case, as in the integrated circuit device 20b described with reference to FIG. 9, the backside source/drain capping layer P212 may include a portion overlapping the gap-fill insulating region P1 of the gap-fill insulating film 202 in the first horizontal direction (e.g., the X direction).

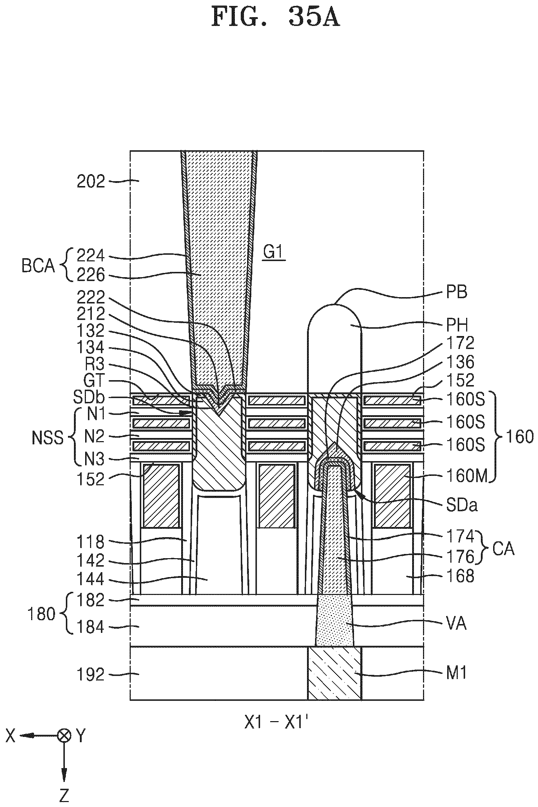

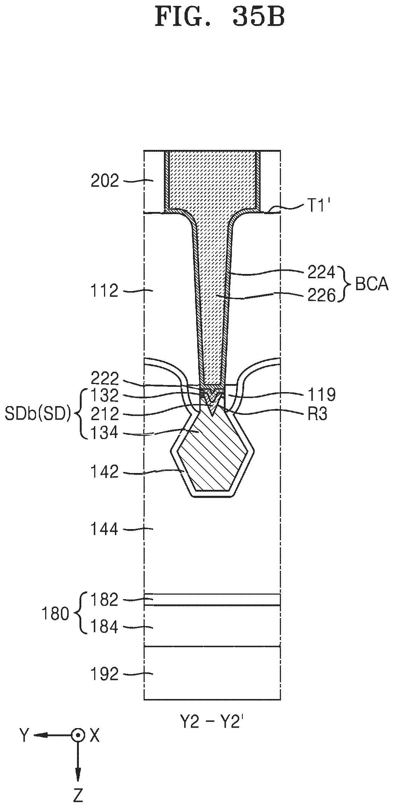

Referring to FIGS. 35A and 35B, a portion of the preliminary backside source/drain capping layer P212 of FIGS. 34A and 34B may be consumed to form a backside metal silicide film 222. In example embodiments, to form the backside metal silicide film 222, a process of forming a metal liner (not shown) conformally covering and overlapping an exposed surface of the preliminary backside source/drain capping layer P212 and a process of inducing a reaction between the preliminary backside source/drain capping layer P212 and a metal constituting the metal liner may be included. After the backside metal silicide film 222 is formed, a remaining portion of the metal liner may be removed. In example embodiments, if the backside metal silicide film 222 includes a titanium silicide film, the metal liner may include a Ti film.

Thereafter, a backside source/drain contact BCA including a conductive barrier pattern 224 and a contact plug 226 may be formed on the backside metal silicide film 222.

## Claims

1. An integrated circuit device (10, 20) comprising:
a plurality of device isolation films (112) extending lengthwise in a first horizontal direction (X) and spaced apart from each other in a second horizontal direction intersecting with the first horizontal direction (X);
a plurality of gate lines (160) disposed on the plurality of device isolation films (112) and extending lengthwise in the second horizontal direction (Y);
a first source/drain region (SDa) and a second source/drain region (SDb) respectively disposed between the plurality of gate lines (160); and
at least one source/drain contact (CA) above the first source/drain region (SDa) and the second source/drain region (SDb),
wherein each of the first source/drain region (SDa) and the second source/drain region (SDb) includes:
a source/drain barrier layer (132);
a source/drain body layer (134) on the source/drain barrier layer (132); and
a source/drain capping layer (136) on the source/drain body layer (134),
wherein a doping concentration of the source/drain capping layer (136) is greater than a doping concentration of the source/drain body layer (134),
wherein the doping concentration of the source/drain body layer (134) is greater than a doping concentration of the source/drain barrier layer (132), and
wherein the source/drain capping layer (136) includes a pointed portion (PT1).

2. The integrated circuit device (10, 20) of claim 1, wherein the at least one source/drain contact (CA) is configured in plurality to be electrically connected to the first source/drain region (SDa) and the second source/drain region (SDb), respectively.

3. The integrated circuit device (10, 20) of claim 1 or 2, wherein the source/drain capping layer (136) is surrounded by the source/drain barrier layer (132) and the source/drain body layer (134).

4. The integrated circuit device (10, 20) of any one of claims 1 to 3, wherein the pointed portion (PT1) of the source/drain capping layer (136) includes a vertex (VT1).

5. The integrated circuit device (10, 20) of any one of claims 1 to 4, further comprising:
a plurality of backside source/drain contacts (BCA) below at least one of the first source/drain region (SDa) and the second source/drain region (SDb),
wherein the first source/drain region (SDa) is electrically connected to one of the at least one source/drain contact (CA), and
wherein the second source/drain region (SDb) is electrically connected to one of the plurality of backside source/drain contacts (BCA).

6. The integrated circuit device (10, 20) of any one of claims 1 to 5, wherein the second source/drain region (SDb) further includes a backside source/drain capping layer (212) interposed between the backside source/drain contact (BCA) and the source/drain body layer (134).

7. The integrated circuit device (10, 20) of claim 6, wherein the backside source/drain capping layer (212) is surrounded by the source/drain barrier layer (132) and the source/drain body layer (134).

8. The integrated circuit device (10, 20) of claim 6 or 7, wherein the backside source/drain capping layer (212) includes at least one pointed portion (PT2).

9. The integrated circuit device (10, 20) of any one of claims 1 to 8,
wherein the source/drain capping layer (136) includes a SiGe film including a p-type dopant, and
wherein the concentration of the p-type dopant is in a range from about 5 × 10²⁰ at/cm³ to about 2 × 10²¹ at/cm³.

10. The integrated circuit device (10, 20) of any one of claims 1 to 9,
wherein the source/drain capping layer (136) includes an Si film including an n-type dopant, and
wherein the concentration of the n-type dopant is in a range from about 5 × 10²⁰ at/cm³ to about 2 × 10²¹ at/cm³.

11. The integrated circuit device (10, 20) of any one of claims 1 to 10, further comprising:
a plurality of fin-type active regions respectively disposed between the plurality of device isolation films (112),
wherein the plurality of fin-type active regions includes a compound semiconductor.

12. The integrated circuit device (10, 20) of any one of claims 1 to 11, further comprising:
a plurality of gap-fill insulating films respectively disposed between the plurality of device isolation films (112),
wherein the plurality of gap-fill insulating films include a silicon oxide film, a silicon nitride film, or a silicon oxynitride film.

13. An integrated circuit device (10, 20) comprising:
a plurality of device isolation films (112) extending lengthwise in a first horizontal direction (X) and spaced apart from each other in a second horizontal direction intersecting with the first horizontal direction (X);
a plurality of gate lines (160) disposed on the plurality of device isolation films (112) and extending lengthwise in the second horizontal direction (Y);
a first source/drain region (SDa) and a second source/drain region (SDb) respectively disposed between the plurality of gate lines (160); and
a plurality of source/drain contacts (CA) above the first source/drain region (SDa) and the second source/drain region (SDb),
wherein each of the first source/drain region (SDa) and the second source/drain region (SDb) includes:
a source/drain barrier layer (132); and
a source/drain body layer (134) on the source/drain barrier layer (132), and wherein the first source/drain region (SDa) further includes:
a source/drain recess (R2) recessed inward from an upper surface of the first source/drain region (SDa); and
a source/drain capping layer (136) disposed in the source/drain recess (R2).

14. The integrated circuit device (10, 20) of claim 13, further comprising:
an insulating liner (142) disposed between the plurality of source/drain contacts (CA) and a gate line (160) adjacent to the plurality of source/drain contacts (CA) among the plurality of gate lines (160),
wherein at least a portion of an upper surface of the source/drain capping layer (136) is overlapped with the insulating liner (142).

15. The integrated circuit device (10, 20) of claim 13 or 14, further comprising:
at least one nanosheet (N1-N3) surrounded by the plurality of gate lines (160),
wherein the source/drain capping layer (136) overlaps the at least one nanosheet (N1-N3) in the first horizontal direction (X).
